(19) Europäisches Patentamt
European Patent Office
Office européen des brevets

(11) **EP 2 299 598 A2**

(12) **EUROPEAN PATENT APPLICATION**

(43) Date of publication:
**23.03.2011 Bulletin 2011/12**

(51) Int Cl.:
*H03M 13/27* (2006.01)     *H03M 13/29* (2006.01)

(21) Application number: **10011906.4**

(22) Date of filing: **22.03.2001**

(84) Designated Contracting States:
**BE CH DE ES FR GB LI**

(30) Priority: **31.03.2000  JP 2000099669**

(62) Document number(s) of the earlier application(s) in accordance with Art. 76 EPC:
**01915681.9 / 1 184 990**

(27) Previously filed application:
**22.03.2001 PCT/JP01/02259**

(71) Applicant: **MITSUBISHI DENKI KABUSHIKI KAISHA**
**Chiyoda-ku**
**Tokyo 100-8310 (JP)**

(72) Inventor: **Matsumoto, Wataru**
**Chiyoda-ku**
**Tokyo 100-8310 (JP)**

(74) Representative: **Pfenning, Meinig & Partner GbR**
**Patent- und Rechtsanwälte**
**Theresienhöhe 13**
**80339 München (DE)**

Remarks:
This application was filed on 30-09-2010 as a divisional application to the application mentioned under INID code 62.

(54) **Turbo coding for a multi-carrier communication system**

(57)     A turbo encoder has a configuration provided with rearrangement unit which generates N types of random series by arranging random series generated by using prime numbers in a buffer of N (where N is a natural number) rows x M (where M is a natural number) columns and rearranging bits in rows by using the random series, generating a final rearrangement pattern by mapping interleaver-length data series on the rearranged N types of random series, and replacing rows in the mapped data series in accordance with a predetermined rule, and finally reading the generated rearrangement pattern in columns.

FIG.1

EP 2 299 598 A2

**Description**

TECHNICAL FIELD

The present invention relates to a communication apparatus using the multicarrier modulation/demodulation system, particularly to a communication apparatus and a communication method for making it possible to realize data communication using an existing communication line in accordance with the DMT (Discrete Multi Tone) modulation-demodulation system or OFDM (Orthogonal Frequency Division Multiplex) modulation/demodulation system. However, the present invention can be applied not only to a communication apparatus for performing data communication in accordance with the DMT modulation/demodulation system but also to every communication apparatus for performing cable communication and radio communication in accordance with the multicarrier modulation/demodulation system and single-carrier modulation/demodulation system through a general communication line.

BACKGROUND ART

A conventional communication apparatus is described below. For example, in the case of the wide-band CDMA (W-CDMA: Code Division Multiple Access) using the SS (Spread Spectrum) system, a turbo code is proposed as an error correction code well over the performance of a convolution cod. The turbo code encodes a series in which an information bit series is interleaved with a known encoding series in parallel and it is the that a characteristic close to the Shannon limit is obtained. Therefore, the turbo code is one of the error correction codes most watched at present. In the case of the above W-CDMA, the performance of an error correction code greatly influences the transmission characteristic in voice transmission or data transmission. Therefore, it is possible to greatly improve the transmission characteristic by using a turbo code.

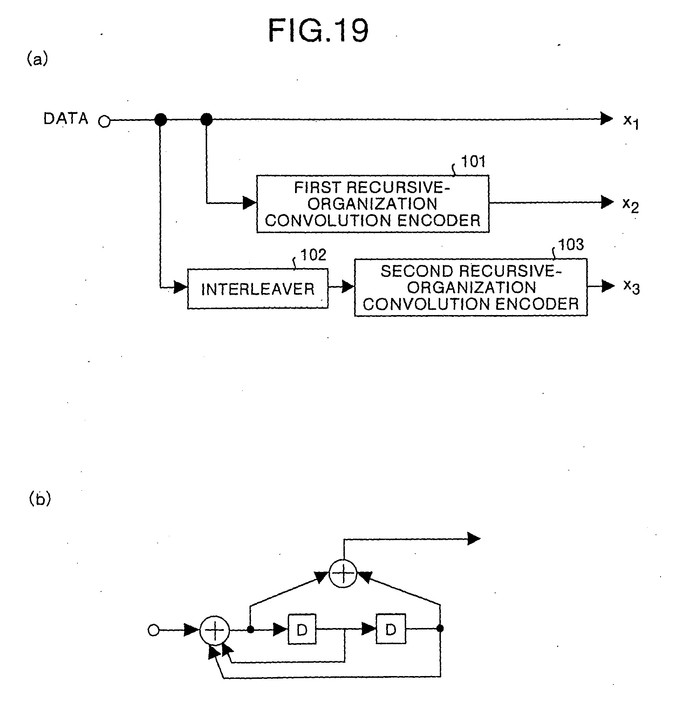

Operations of the transmission system and reception system of a conventional communication apparatus using the above turbo code are specifically described below. Figs. 19(a) and 19(b) are illustrations showing a configuration of a turbo encoder used for a transmission system. In Fig. 19(a), symbol 101 denotes a first recursive-organization convolution encoder for convolution-encoding an information bit series and outputting a redundant bit, 102 denotes an interleaver, and 103 denotes a second recursive-organization convolution encoder for convolution-encoding an information bit series after replaced by the interleaver 102 and outputting a redundant bit. Fig. 19(b) is an illustration showing internal configurations of the first recursive-organization convolution encoder 101 and the second recursive-organization convolution encoder 103 and these two recursive-organization convolution encoders respectively serve as an encoder for outputting only a redundant bit. Moreover, the interleaver 102 used for the turbo encoder replaces information bit series at random.

The turbo encoder constituted as described above simultaneously outputs an information bit series $x_1$, a redundant bit series $x_2$ obtained by encoding the information bit series by the first recursive-organization convolution encoder 101, and a redundant bit series $x_3$ obtained by encoding an information bit series interleaved by the second recursive-organization convolution encoder 103.

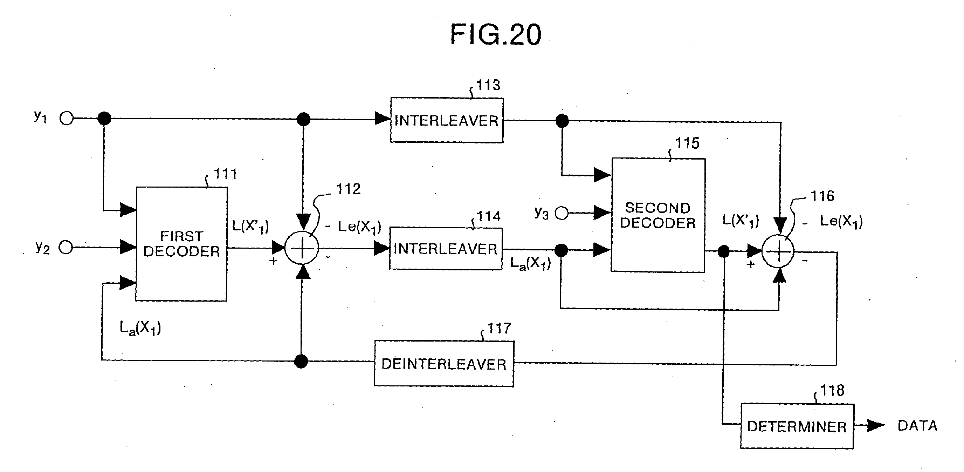

Fig. 20 is an illustration showing a configuration of a turbo decoder used for a reception system. In Fig. 20, reference numeral 111 denotes a first decoder for calculating a logarithmic likelihood ratio in accordance with reception signal $y_1$ and reception signal $y_2$, reference numerals 112 and 116 respectively denote an adder, reference numerals 113 and 114 respectively denote an interleaver, reference numeral 115 denotes a second decoder for calculating a logarithmic likelihood ratio in accordance with the reception signal $y_1$ and reception signal $y_3$, reference numeral 117 denotes a deinterleaver, and reference numeral 118 denotes an interleaver, reference numeral 118 denotes a determiner for determining an output of the second decoder 115 and outputting an estimated value of an original information bit series. The reception signals $y_1$, $y_2$, and $y_3$ are signals obtained by providing influences of noises and fading of a transmission line for the information bit series $x_1$ and redundant bit series $x_2$ and $x_3$.

In the case of the turbo decoder constituted as described above, the first decoder 111 first calculates the logarithmic likelihood ratio $L(x_{1k}')$ of an estimated information bit $x_{1k}'$ estimated in accordance with reception signals $y_{1k}$ and $y_{2k}$ (k denotes time). In this case, the probability that the information bit $x_{1k}$ is equal to 1 to the probability that the information bit $x_{1k}$ is equal 0 is obtained. The illustrated $Le(x_{1k})$ denotes external information and the illustrated $La(x_{1k})$ denotes advance information that is the last external information.

The adder 112 calculates the external information for the second decoder 115 in accordance with the logarithmic likelihood ratio which is the above calculation result. In the case of the first decoding, $La(x_{1k})$ is equal to 0 because advance information is not obtained.

The interleavers 113 and 114 rearranges signals in order to adjust the reception signal $y_{1k}$ and external information $Le(x_{1k})$ to the time of the reception signal $y_3$. Thereafter, the second decoder 115 calculates a logarithmic likelihood ratio $L(x_{1k}')$ in accordance with the reception signal y1 and reception signal y3 and the previously calculated external information $Le(x_{1k})$ similarly to the case of the first decoder 111. The external information rearranged by the deinterleaver 117 is returned to the first decoder 111 as the advance information $La(x_{1k})$.

Finally, the turbo decoder calculates a more-accurate logarithmic likelihood ratio by repeatedly executing the above processing up to predetermined times and then, the determiner 118 performs determination in accordance with the logarithmic likelihood ratio to estimate the original information bit series. Specifically, for example, the determiner determines an estimated information bit $x_{1k}'$ as 1 when the logarithmic likelihood ratio $L(x_{1k}')$ is larger than 0 and the bit $x_{1k}'$ as 0 when the ratio $L(x_{1x}')$ is equal to or less than 0.

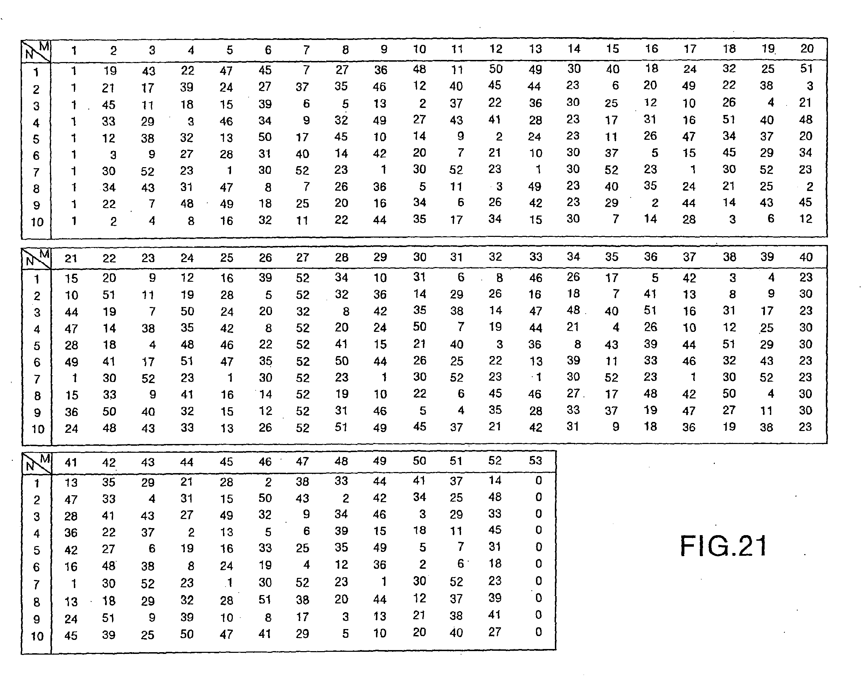

Fig. 21, Fig 22, and Fig 23 are illustrations showing processings performed by the interleaver 102 used for the above turbo encoder. The processing for replacing information bit series at random by the interleaver 102 is described below.

For example, W-CDMA generally uses a complex interleaver (hereafter referred to as PIL). A PIL has the following three features.

    1. Replacing rows and columns of N(ordinate axis: natural number) $\times$ M(abscissa axis: natural number) buffers.
    2. Adopting pseudo random patterns using prime numbers for bit replacement in rows.
    3. Avoiding critical patterns by replacing rows.

Operations of the PIL that is a conventional interleaver are described below. For example, when assuming interleaver length $L_{turbo}=512$ bits, N=10, M=P=53 ($L_{turbo}/N \leq P+1$), and primitive root $g_0=2$, a mapping pattern c(i) is shown by the following expression (1).

$$c(i) = (g_0 \times c(i-1)) = mod P \qquad \ldots(1)$$

In the above expression, it is assumed that i=1, 2, ... , (P-2) and c(0)=1.

Therefore, the mapping pattern C(i) is shown as {1, 2, 4, 8, 16, 32, 11, 22, 44, 35, 17, 34, 15, 30, 7, 14, 28, 3, 6, 12, 24, 48, 43, 33, 13, 26, 52, 51, 49, 45, 37, 21, 42, 31, 9, 18, 36, 19, 38, 23, 46, 39, 25, 50, 47, 41, 29, 5, 10, 20, 40, 27}.

Moreover, the PIL replaces bits by skip-reading the mapping pattern C(i) every skip-read pattern $P_{PIP(j)}$ and generates a mapping patter $c_j(i)$ of j rows. In this case, {$q_j$(j ranges between 1 and N-1)} is determined in accordance with conditions of the following expressions (2), (3), and (4) in order to obtain {$P_{PIP(j)}$}.

$$q_0 = 1 \qquad \ldots(2)$$

$$g.c.d\{q_j, P-1\} = 1 \qquad \ldots(3)$$

where g.c.d denotes a greatest common divisor

$$q_j > 6, \quad q_j > q_{j-1} \qquad \ldots(4)$$

where j ranges between 1 and N-1

Therefore, {$q_j$} is shown as {1, 7, 11, 13, 17, 19, 23, 29, 31, 37} and {$P_{PIP(j)}$} is shown as {37, 31, 29, 23, 19, 17, 13, 11, 7, 1} (in this case, PIP ranges between N-1 and 0). Fig. 21 is an illustration showing a result of skip-reading the mapping pattern C(i) in accordance with the skip-read pattern $P_{PIP(j)}$, that is, a result of rearranging rows in skip-read patterns.

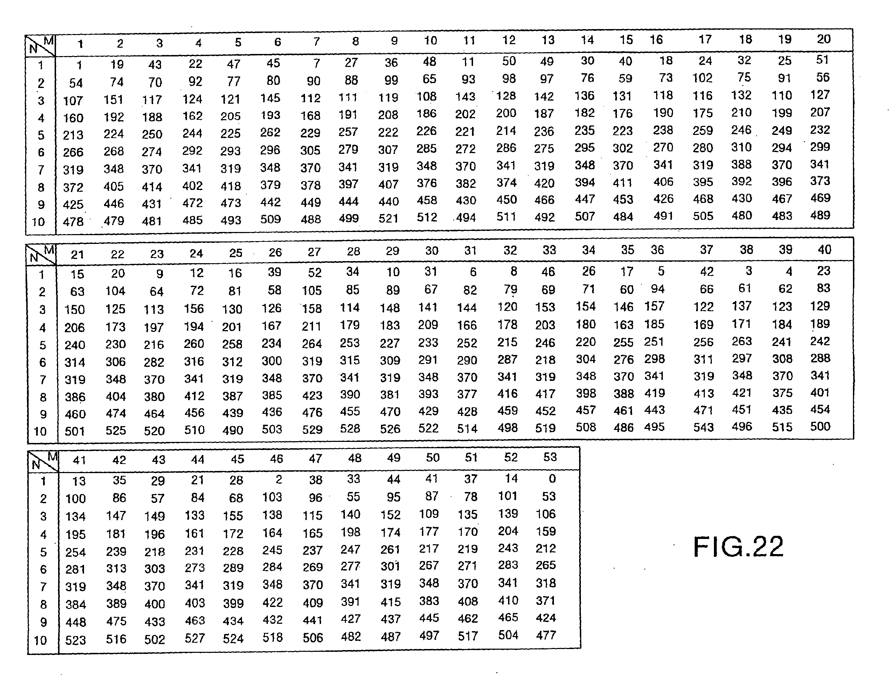

Fig. 22 is an illustration showing the data arrangement when mapping the data for interleaver length $L_{turbo}=512$ bits on the above rearranged mapping pattern. In this case, data {0-52} is mapped on the first row, data {53-105} is mapped on the second row, data {106-158} is mapped on the third row, data {159-211} is mapped on the fourth row, data {212-264} is mapped on the fifth row, data {265-317} is mapped on the sixth row, data {318-370} is mapped on the seventh row, data {371-423} is mapped on the eighth row, data {424-476} is mapped on the ninth row, and data {477-529} is mapped on the tenth row.

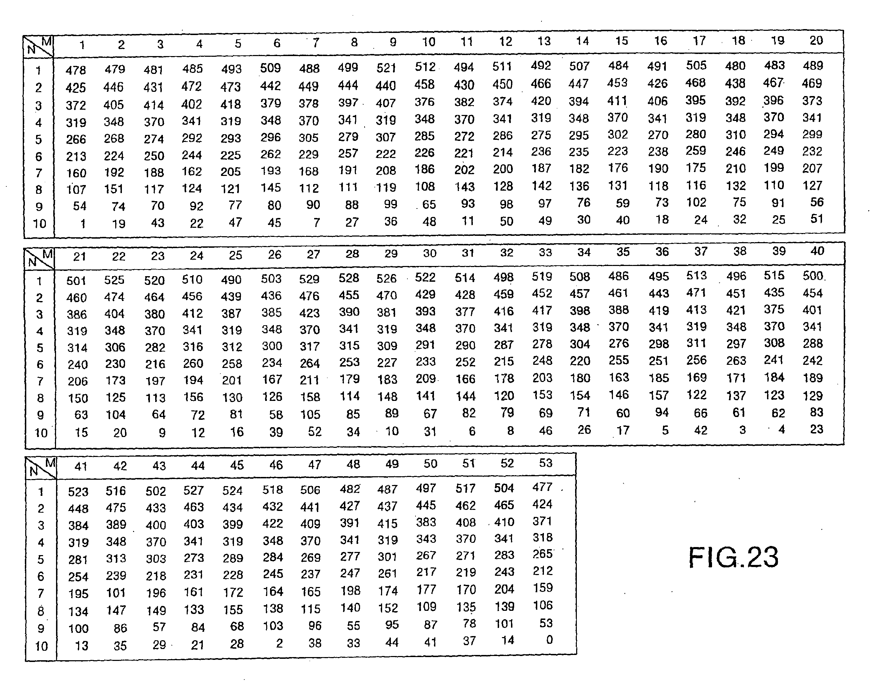

Fig. 23 is an illustration showing a final rearrangement pattern. In this case, rows in the data arrangement in Fig. 23 are replaced in accordance with a predetermined rule to generate a final rearrangement pattern (in this case, the sequence of rows in the data arrangement in Fig. 23 is reversed). Then, the PIL reads the generated rearrangement patterns in columns, that is, vertically reads the patterns.

Thus, by using the PIL for interleaving, it is possible to provide a turbo code for generating code words serving as a preferable weight distribution in a wide-range interleaving length (for example, $L_{turbo}$ = 257 to 819 bits).

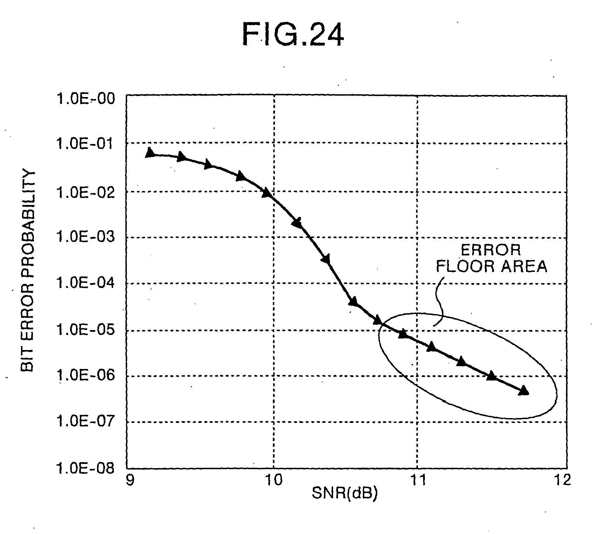

Fig. 24 is an illustration showing the BER (bit error rate) characteristic when using conventional turbo encoder and turbo decoder including the above PIL. As shown in Fig. 24, the BER characteristic is improved as SNR rises. For example, when determining the performance of a turbo code by using the BER as shown in Fig. 24, "minimum hamming weight $w_{min}$ after turbo encoding influences the BER of a high SNR. Specifically, it is generally known that when the minimum hamming weight is small, the BER in an error floor area (area in which drop of the BER becomes moderate) rises.

The minimum hamming weight denotes the minimum value of the number of "1" of patterns which can be taken by the series ($x_1$, $x_2$, and $x_3$) shown in Fig. 19(a). Therefore, when the following code words form a pattern showing the minimum value of the number of "1", the minimum hamming weight $W_{min}$ of the turbo encoder becomes 7.

    x1 = 00100100000
    x2 = 00010100000
    x3 = 00010101000

In this case, x1 and x2 denote input data series of the encoder and x3 denotes a data series output from the encoder.

Thus, in the case of a conventional communication apparatus, it is possible to greatly improve voice transmission and data transmission characteristics and obtain a characteristic superior to that of a known convolution cod even when an inter-signal-point distance is decreased in accordance with the change of a modulation system to a multiple value by using a turbo code as an error correction code.

Moreover, the conventional communication apparatus turbo-encodes all input information series (or all information bit series), moreover turbo-decodes all signals encoded at the reception side, and then performs soft determination. Specifically, the apparatus determines all 4-bit data (0000-1111: 4-bit constellation) for 16 QAM and all 8-bit data for 256 QAM.

However, the above conventional communication apparatus using turbo codes has problems that it is necessary to improve the encoder (corresponding to a recursive-organization convolution encoder and interleaver used for the conventional turbo encoder shown in Fig. 19 (b) and turbo encoding using the conventional encoder and interleaver cannot obtain an optimum transmission characteristic close to the Shannon limit, that is, an optimum BER characteristic.

Moreover, the above conventional turbo encoder has a problem that it is specified to information bit series of one system but it does not correspond to information bit series of two systems.

As described above, it is an object of the present invention to provide a communication apparatus and a communication method which can be applied to all communications using the multicarrier modulation system and single-carrier demodulation system and moreover capable of greatly improving the BER characteristic compared to the conventional case.

DISCLOSURE OF THE INVENTION

The communication apparatus according to one aspect of the present invention comprises a turbo encoder that includes a rearrangement unit which generates N types of random series by arranging random series generated with prime numbers in a buffer of N (where N is a natural number) rows $\times$ M (where M is a natural number) columns and rearranging bits in rows with the above random series, generating a final rearrangement pattern by mapping interleaver-length data series on the arranged N types of random series and rearranging rows in the mapped data series in accordance with a predetermined rule, and reading the generated rearrangement pattern in columns.

The communication apparatus according to one another aspect of the present invention comprises a turbo encoder that includes a rearrangement unit which generates N types of random series by arranging random series generated with prime numbers in a buffer of N (where N is a natural number) rows $\times$ M (where M is a natural number) columns and shifting the random series one column by one column in rows, by using the random series and thereby rearranging bits in rows, generating a final rearrangement pattern by mapping interleaver-length data series on the rearranged N types of random series and replacing rows in the mapped data series in accordance with a predetermined rule, and reading the generated rearrangement pattern in columns.

In the communication apparatus according to another aspect of the present invention, when two information bit series are input into the above turbo encoder, the above rearrangement unit rearranges the two information bit series so that the inter-signal-point distance of the two information bit series does not become 0.

The communication method according to still another aspect of the present invention includes a random-series generating step of generating N types of random series by arranging random series generated with prime numbers in a buffer of N (where N is a natural number) rows × M (where M is a natural number) columns and rearranging bits in rows with the random series, a mapping step of mapping interleaver-length data series on the rearranged N types of random series, a rearrangement-pattern generating step of generating a final rearrangement pattern by replacing rows in the mapped data series in accordance with a predetermined rule, and a reading step of reading the generated rearrangement pattern in columns.

The communication method according to still another aspect of the present invention includes a random-series generating step of generating N types of random series by arranging random series generated with prime numbers in a buffer of N (where N is a natural number) rows × M (where M is a natural number) columns and shifting the random series in rows, a mapping step of mapping interleaver-length data series on the shifted N types of random series, a rearrangement-pattern generating step of generating a final rearrangement pattern, and a reading step of reading the generated rearrangement pattern in columns.

In the communication method according to still another aspect of the present invention, when two information bit series are input into the above turbo encoder, the two information bit series are rearranged so that inter-signal-point distances of the two information bit series do not become 0.

BRIEF DESCRIPTION OF THE DRAWINGS

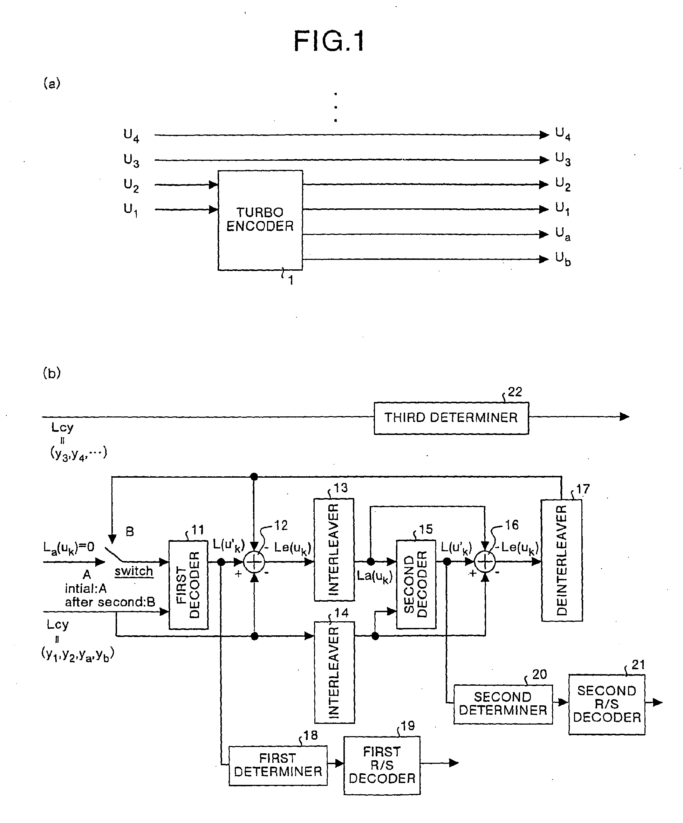

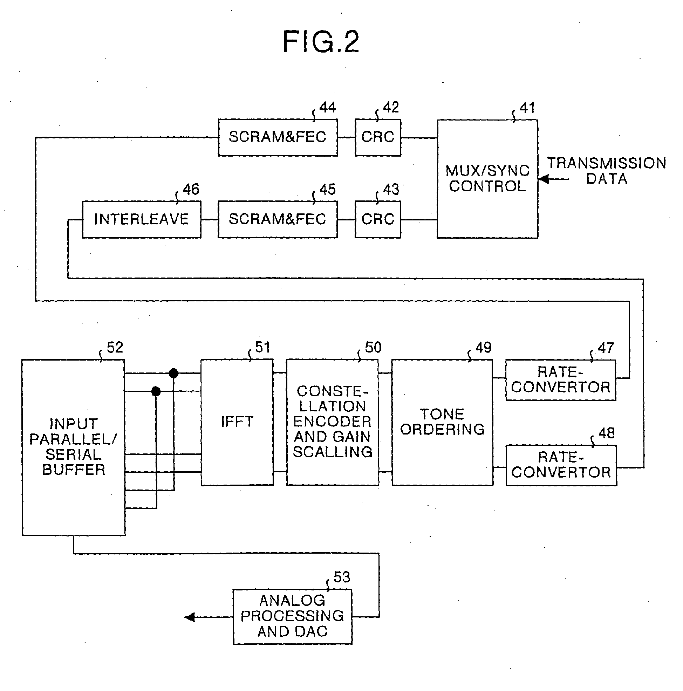

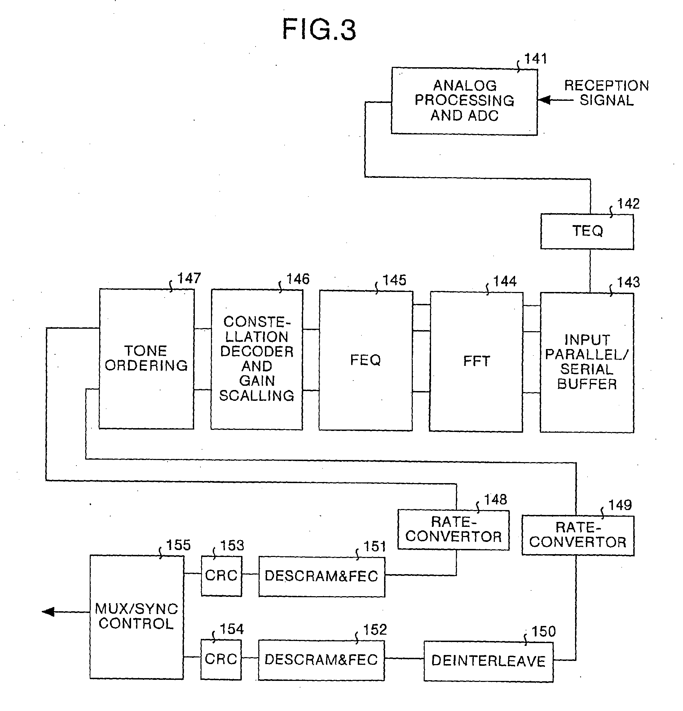

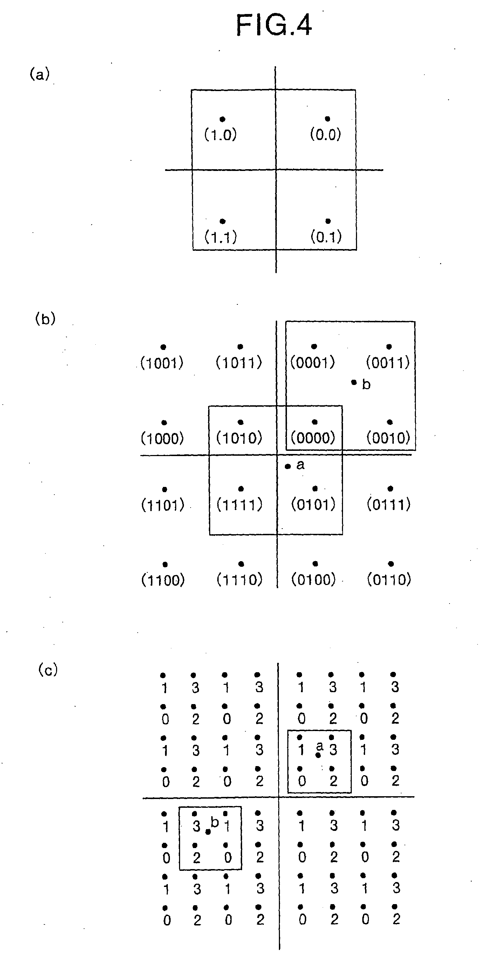

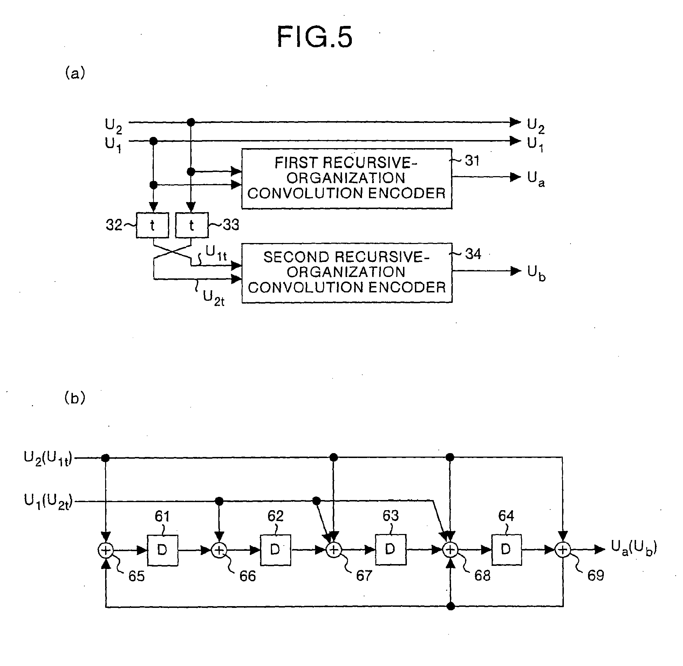

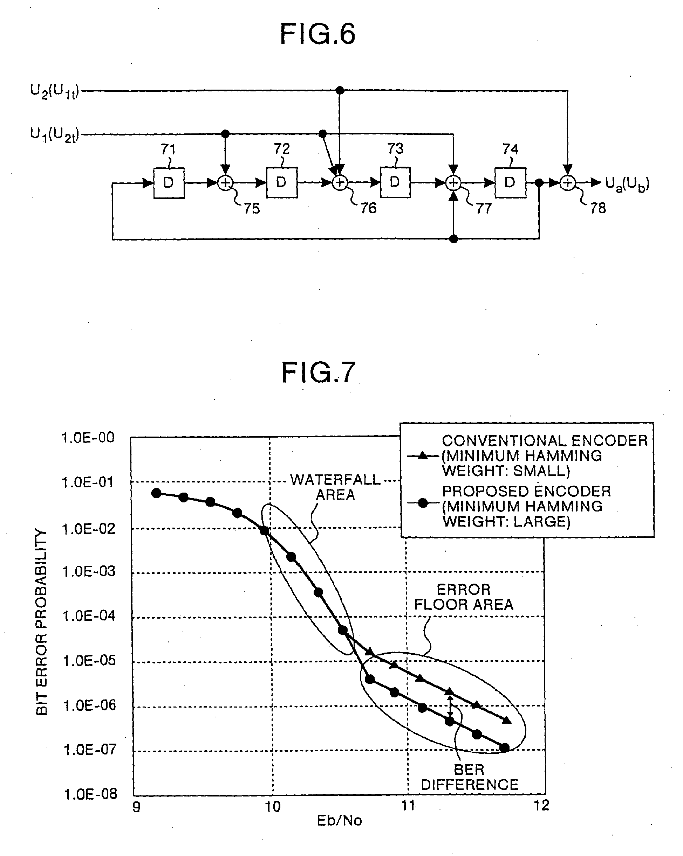

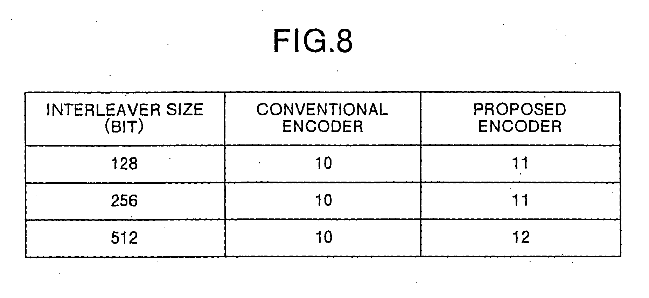

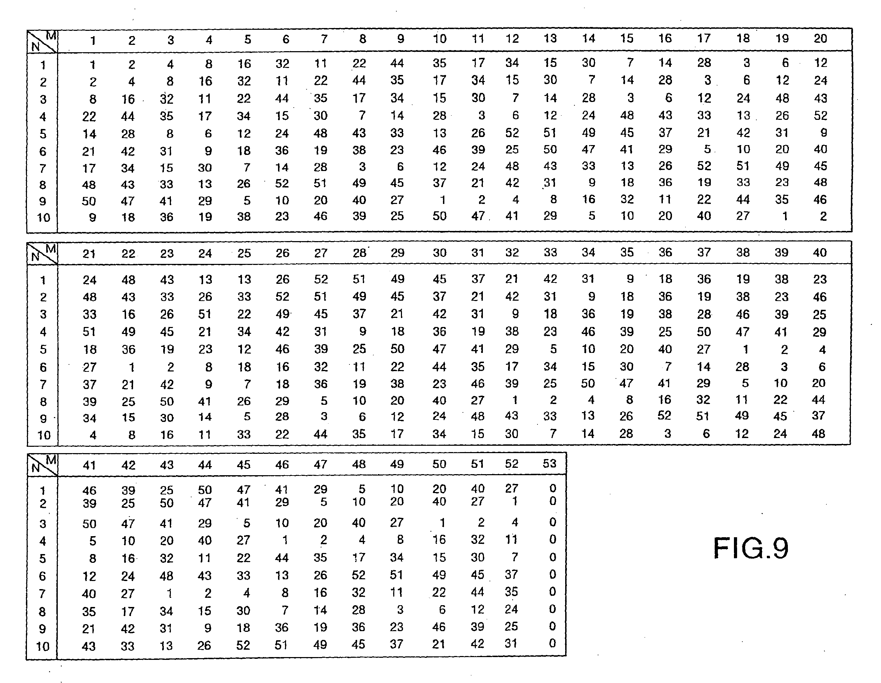

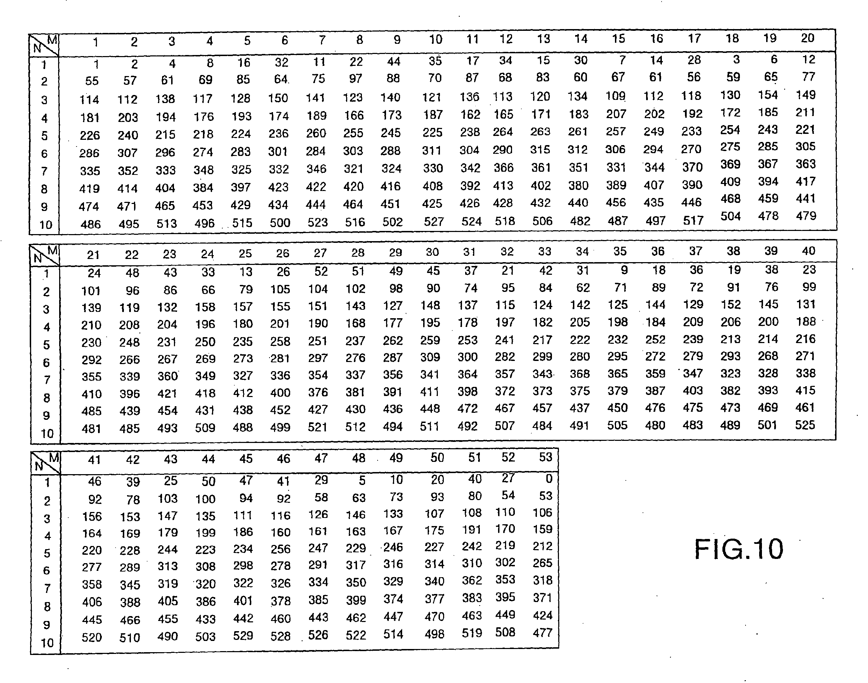

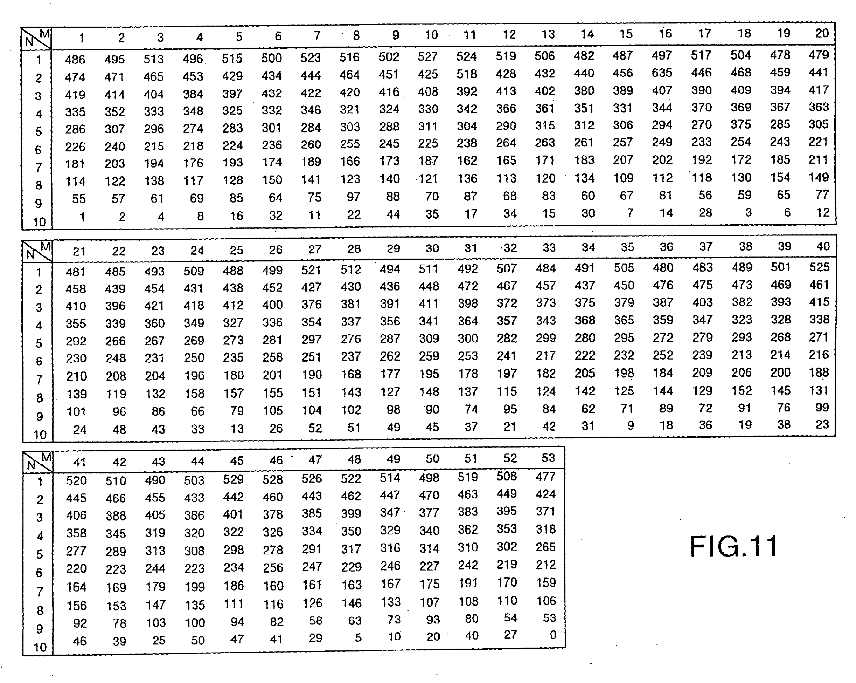

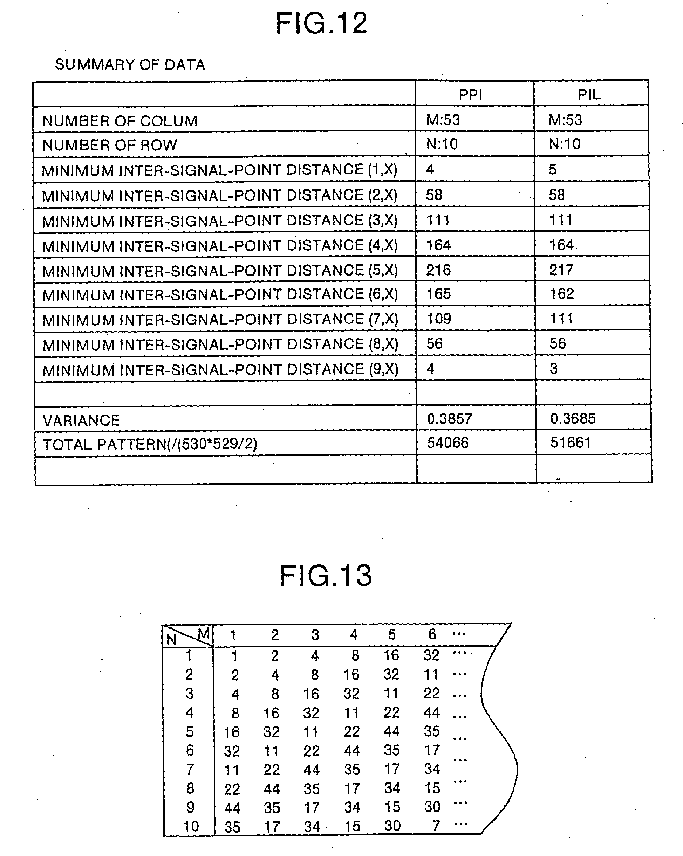

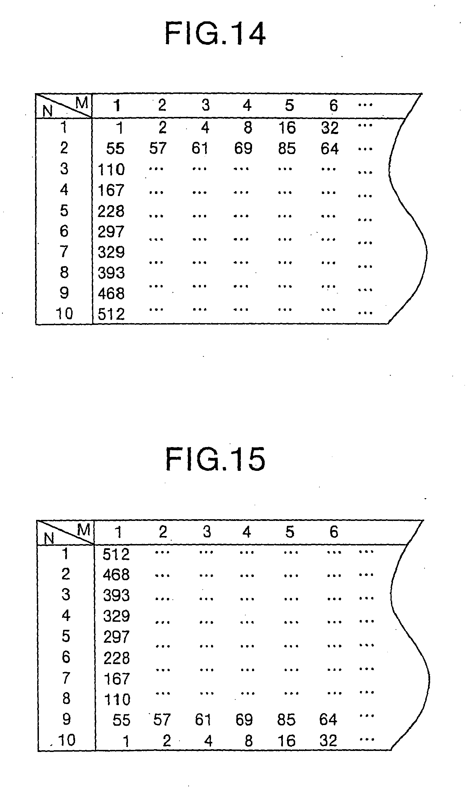

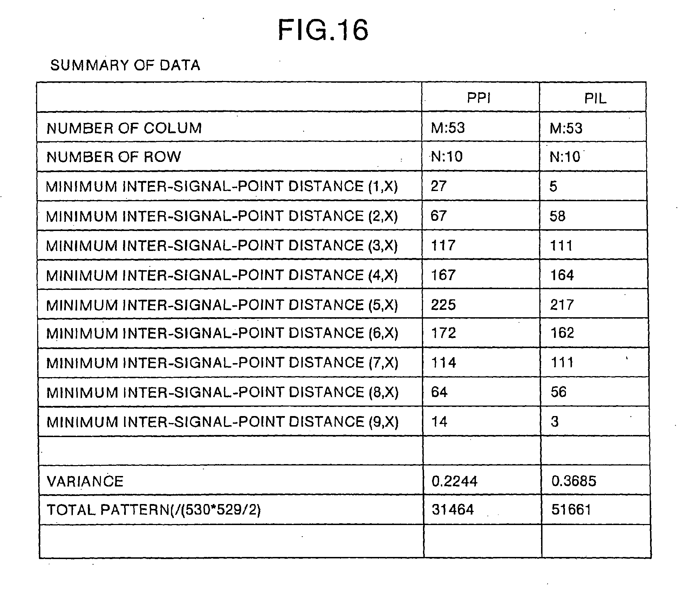

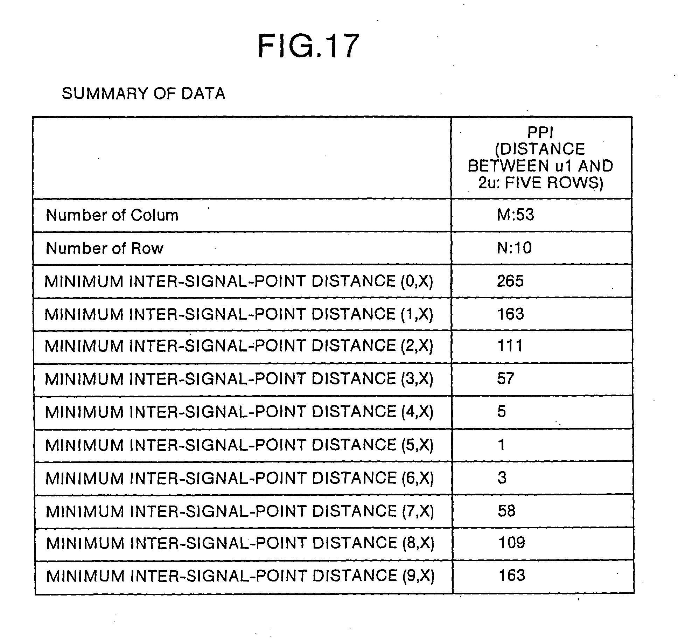

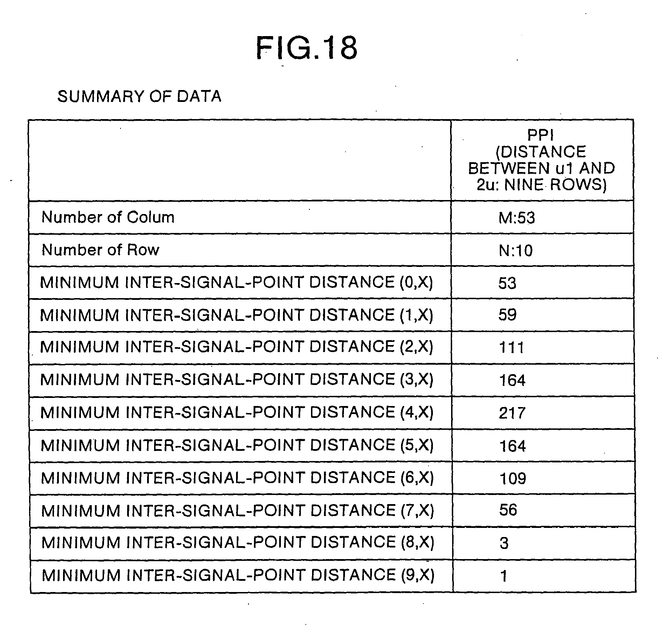

Fig. 1 is an illustration showing configurations of an encoder and a decoder used for a communication apparatus of the present invention; Fig. 2 is an illustration showing a configuration of a transmission system of a communication apparatus of the present invention; Fig. 3 is an illustration showing a configuration of a reception system of a communication apparatus of the present invention; Fig. 4 is an illustration showing signal-point arrangements of various digital modulations; Fig. 5 is an illustration showing a configuration of a turbo encoder 1; Fig. 6 is an illustration showing a recursive-organization convolution encoder constituting the same code as that of the recursive-organization convolution encoder in Fig. 5(b); Fig. 7 is an illustration showing the BER characteristic when decoding transmission data by using a turbo encoder of the present invention and the BER characteristic when decoding transmission data by using a conventional turbo encoder; Fig. 8 is an illustration showing the minimum hamming weight of a turbo encoder of the present invention and the minimum hamming weight of a conventional turbo encoder when using a certain interleaver size; Fig. 9 is an illustration showing the processing by a first embodiment of an interleaver used for a turbo encoder of the present invention; Fig. 10 is an illustration showing the processing by the first embodiment of an interleaver used for a turbo encoder of the present invention; Fig. 11 is an illustration showing the processing by the first embodiment of an interleaver used for a turbo encoder of the present invention; Fig. 12 is an illustration quantitatively comparing the PPI of the first embodiment with a conventional PIL; Fig. 13 is an illustration showing the processing by a second embodiment of an interleaver used for a turbo encoder of the present invention; Fig. 14 is an illustration showing the processing by the second embodiment of an interleaver used for a turbo encoder of the present invention; Fig. 15 is an illustration showing the processing by the second embodiment of an interleaver used for a turbo encoder of the present invention; Fig. 16 is an illustration quantitatively comparing a PPI of the second embodiment with a conventional PIL; Fig. 17 is an illustration showing inter-signal-point distances of information bit series U1 and U2 when assuming the distance between U1 and U2 as five rows; Fig. 18 is an illustration showing optimum values of two interleavers when performing rearrangement in accordance with the condition same as the case of the first embodiment; Fig. 19 is an illustration showing a configuration of a conventional turbo encoder used for a transmission system; Fig. 20 is an illustration showing a configuration of a conventional turbo encoder used for a reception system; Fig. 21 is an illustration showing the processing by an interleaver used for a conventional turbo encoder; Fig. 22 is an illustration showing the processing by an interleaver used for a conventional turbo encoder; Fig. 23 is an illustration showing the processing by an interleaver used for a conventional turbo encoder; and Fig. 24 is an illustration showing a bit error rate characteristic when using a conventional turbo encoder and turbo decoder.

BEST MODE FOR CARRYING OUT THE INVENTION

Embodiments of a communication apparatus of the present invention are described below by referring to the accompanying drawings. However, the present invention is not restricted to the embodiments.

First Embodiment:

Fig. 1 is an illustration showing configurations of an encoder (turbo encoder) and a decoder (combination of turbo decoder, hard determiner, and R/S (Reed-Solomon) decoder). Concretely speaking, Fig. 1(a) is an illustration showing the configuration of the encoder of this embodiment and Fig. 1(b) is an illustration showing the configuration of the decoder of this embodiment.

It is assumed that the communication apparatus of this embodiment is provided with both the encoder and decoder and a superior transmission characteristic is obtained in data communication and voice communication by having a high-accuracy data error correction capacity. It is assumed that this embodiment is provided with the above both configurations for convenience's sake of description. However, for example it is also permitted to assume a transmitter provided with only the above encoder or a receiver provided with only the above decoder.

In the case of the encoder in Fig. 1(a), reference numeral 1 denotes a turbo encoder capable of obtaining a performance close to the Shannon limit by using a turbo code as an error correction code. For example, the turbo encoder 1 outputs information bits of two bits and redundant bits of two bits when information bits of 2 bits are input and moreover, in this case, generates each of the redundant bits so that correction capacities for each of the information bits become uniform at the reception side.

On one hand, in the case of the decoder in Fig. 1(b), reference numeral 11 denotes a first decoder for calculating a logarithmic likelihood ratio in accordance with a reception signal Lcy (corresponding to reception signals $y_2$, $y_1$, and $y_a$ to be described later), reference numerals 12 and 16 denote an adder, reference numerals 13 and 14 respectively denote an interleaver, reference numeral 15 denotes a second decoder for calculating a logarithmic likelihood ratio in accordance with a reception signal Lcy (corresponding to reception signals $y_2$, $y_1$, and $y_b$ to be described later), reference numeral 17 denotes a deinterleaver, reference numeral 18 denotes a first determiner for determining an output of the decoder 15 and outputting an estimated value of an original information bit series, reference numeral 19 denotes a first R/S decoder for decoding a reed-Solomon code and outputting a more-accurate information bit series, reference numeral 20 denotes a second determiner for determining an output of the second decoder 15 and outputting an estimated value of an original information bit series, reference numeral 21 denotes a second R/S decoder for decoding a reed-Solomon code and outputting a more-accurate information bit series, and reference numeral 22 denotes a third determiner for hard-determining Lcy (corresponding to reception signals $y_3$, $y_4$, ... to be described later) and outputting an estimated value of an original information bit series.

Then, before describing operations of the above encoder and decoder, basic operations of a communication apparatus of the present invention are briefly described by referring to the accompanying drawings. A cable-system digital communication system for communicating data by using, for example, the DMT (Discrete Multi Tone) modulation/demodulation system includes the ADSL (Asymmetric Digital Subscriber Line) communication system for performing high-speed digital communication at several Mbits/sec by using an existing telephone line and the xDSL communication system such as the HDSL (High-bit-rate Digital Subscriber Line) communication system. The cable-system digital communication system is standardized in T1.43 of ANSI. Hereafter, this embodiment uses a communication apparatus applicable to the above ADSL.

Fig. 2 is an illustration showing a configuration of the transmission system of a communication apparatus of the present invention. In Fig. 2, the transmission system multiplexes transmission data by multiplex/sync control (corresponding to MUX/SYNC CONTROL in Fig. 2) 41, an error detection code is added to the multiplexed transmission data by cyclic redundancy check (corresponding to CRC: Cyclic Redundancy Check) 42 and 43, and moreover an FEC code is added to the data by forward error collection (corresponding to SCRAM&FEC) 44 and 45 and scrambling is applied to the data.

Two routes are present from the multiplex/sync control 41 up to the tone ordering 49. One is an interleaved data buffer route in which interleave 46 is included and the other is a fast data buffer not including interleave. In this case, the interleaved data buffer route for performing interleaving has a larger delay.

Thereafter, rate conversion is applied to the transmission data by rate converters (corresponding to RATE-CONVERTER) 47 and 48 and tone ordering is applied to the data by tone ordering (corresponding to TONE ORDERING) 49. Then, constellation data is generated by constellation encoder/gain scaling (corresponding to CONSTELLATION AND GAIN SCALING) 50 in accordance with the tone-ordering-applied transmission data and inverse fast Fourier transform is applied to the data by inverse fast Fourier transform section (corresponding to IFFT: Inverse Fast Fourier transform) 51.

Finally, Fourier-transformed parallel data is converted into serial data by an input parallel/serial buffer (corresponding to INPUT PARALLEL/SERIAL BUFFER) 52, a digital waveform is converted to an analog waveform by an analog processing/digital-analog converter (corresponding to ANALOG PROCESSING AND DAC) 53, filtering is applied to the analog waveform, and then the transmission data is transmitted to a telephone line.

Fig. 3 is an illustration showing a configuration of the reception system of a communication apparatus of the present invention. In Fig. 3, the reception system applies filtering to reception data (above-described transmission data) by analog processing/analog-digital converter (corresponding to ANALOG PROCESSING AND ADC in Fig. 3) 141 to convert an analog waveform to a digital waveform and performs adaptive equalization of a time domain by a time domain equalizer (corresponding to TEQ) 142.

The data to which time-domain adaptive equalization is applied is converted from serial data to parallel data by an input serial/parallel buffer (corresponding to INPUT SERIAL/PARALLEL BUFFER) 143, fast Fourier transform is applied to the parallel data by a fast Fourier transform section (corresponding to FFT: Fast Fourier transform) 144 and then, frequency-domain adaptive equalization is applied to the fast-Fourier-transformed data by a frequency-domain equalizer (corresponding to FEQ) 145.

The data to which frequency-domain adaptive equalization is applied is converted to serial data through decoding (maxim-likelihood decoding method) and tone ordering performed by constellation decoder/gain scaling (corresponding to CONSTELLATION DECODER AND GAIN SCALING) 14 6 and tone ordering (corresponding to TONE ORDERING) 147. Then, rate conversion is applied to the data by rate converters (corresponding to RATE-CONVERTER) 148 and 149, deinterleaving is applied to the data by deinterleave (corresponding to DEINTERLEAVE) 150, FEC and descrambling are applied to the data by forward error correction (corresponding to DESCRAM&FEC) 151 and 152, and cyclic redundancy check is applied to the data by cyclic redundancy check (corresponding to cyclic redundancy check) 153 and 154, and finally reception data is regenerated by multiplex/sync control (corresponding to MUX/SYNC CONTROL) 155.

In the case of the communication apparatus described above, the reception system and transmission system respectively have two routes. By separating or simultaneously operating these two routes, it is possible to realize data communication at a low transmission delay and a high rate.

In the case of the communication apparatus constituted as described above, the encoder shown in Fig. 1(a) is set to the constellation encoder/gain scaling 50 of the above transmission system and the decoder shown in Fig. 1(b) is set to the constellation decoder/gain scaling 146 of the above reception system.

Operations of the encoder (transmission system) and decoder (reception system) of this embodiment are described below by referring to the accompanying drawings. First, operations of the encoder shown in Fig. 1(a) are described below. This embodiment uses, for example, a 16-QAM system for quadrature amplitude modulation (QAM).

Moreover, in the case of the encoder of this embodiment, only low-order 2-bit input data is turbo-encoded and input data is directly output to other high-order bits as shown in Fig. 1(a) differently from the conventional turbo-encoding every input data (4 bits).

The reason for turbo-encoding only low-order 2-bit input data is described below. Fig. 4 is an illustration showing signal-point arrangements of various digital modulations. Precisely, Fig. 4(a) is a signal-point arrangement of the four-phase PSK (Phase Shift Keying) system, Fig. 4 (b) is a signal-point arrangement of the 16-QAM system, and Fig. 4(c) is a signal-point arrangement of the 4-QAM system.

For example, when a reception signal point is present at the position of a or b in signal-point arrangements of all of the above modulation systems, most-probable data is generally estimated as information bit series (transmission data) at the reception side in accordance with soft determination. That is, a signal point closest to a reception signal point is determined as transmission data. In this case, however, when noting the reception signal points a and b in Fig. 4, it is found that low-order two bits of four points closest to the reception signal points are shown as (0, 0), (0, 1), (1, 0), or (1, 1) in any case (corresponding to Fig. (a), 4(b), or 4(c)). Therefore, in the case of this embodiment, turbo encoding having a superior error correction capacity is applied to low-order two bits of four signal points whose characteristics may be deteriorated (that is, four points having the minimum inter-signal-point distance) to perform soft determination at the reception side. On one hand, other high-order bits whose characteristics may not be deteriorated are directly output to perform hard determination at the reception side.

Thereby, in the case of this embodiment, it is possible to improve a characteristic which may be deteriorated in accordance with the change to multiple value and moreover, greatly reduce throughput compared to the conventional turbo-encoding every bit because only low-order two bits of a transmission signal are turbo-encoded.

Operations of the turbo encoder 1 shown in Fig. 1(a) for turbo-encoding input low-order two-bit transmission data $u_1$ and $u_2$ are described below. For example, Fig. 5 is an illustration showing a configuration of the turbo encoder 1. Precisely, Fig. 5(a) is an illustration showing a block diagram of the turbo encoder 1 and Fig. 5 (b) is an illustration showing a circuit configuration of a recursive-organization convolution encoder. In this case, the configuration in Fig. 5 (b) is used as the recursive-organization convolution encoder. Moreover, it is permitted to use a recursive-organization convolution encoder same as ever or other known recursive-organization convolution encoder.

In Fig. 5(a), reference numeral 31 denotes a first recursive-organization convolution encoder for convolution-encoding transmission data $u_1$ and $u_2$ corresponding to an information bit series and outputting redundant data $u_a$, reference numerals 32 and 33 denote interleavers, and 34 denotes a second recursive-organization convolution encoder for convolution-encoding interleaved data $u_{1t}$ and $u_{2t}$ and outputting redundant data $u_b$. The turbo encoder 1 simultaneously outputs transmission data $u_1$ and $u_2$, redundant data $u_a$ obtained by encoding the transmission data through the processing by the first recursive-organization convolution encoder 31 and redundant data $u_b$ (different from other data in time) obtained by encoding interleaved data through the processing by the second recursive-organization convolution encoder 34.

Moreover, in the case of the recursive-organization convolution encoder shown in Fig. 5(b), reference numerals 61, 62, 63, and 64 denote delay units and reference numerals 65, 66, 67, 68, and 69 denote adders. In the case of the recursive-organization convolution encoder, the first-stage adder 65 adds and outputs the input data $u_2$ (or data $u_{1t}$) and the returned redundant data $u_a$ (or redundant data $u_b$), the second-stage adder 66 adds and outputs the input transmission data $u_1$ (or data $u_{2t}$) and an output of the delay unit 61, the third-stage adder 67 adds and outputs the input transmission data $u_2$ (or data $u_{1t}$) and an output of the delay unit 62, the fourth-stage adder 68 adds and outputs the input transmission

data $u_1$ (or data $u_{2t}$), the transmission data $u_2$ (or data $u_{1t}$), an output of the delay unit 63, and the returned redundant data $u_a$ (or redundant data $u_b$), and the final-stage adder 69 adds the input transmission data $u_2$ (or data $u_{1t}$) and an output of the delay unit 64 and finally outputs the redundant data $u_a$ (redundant data $u_b$).

Thus, the turbo encoder 1 uniforms estimation accuracies of the transmission data $u_1$ and $u_2$ at the reception side using redundant data $u_a$ and $u_b$ so that weights of redundant bits are not deviated. That is, to uniform estimation accuracies of the transmission data $u_1$ and $u_2$, for example the numbers of delay units through which data passes are equalized between the series of the transmission data $u_1$ and the series of the transmission data $u_2$ by inputting the transmission data u2 to the adders 65, 67, 68, and 69 of the first recursive-organization convolution encoder 31 (refer to Fig. 5(b)), the interleaved data $u_2$ to the adders 66 to 68 of the second recursive-organization convolution encoder 34 while inputting the transmission data u1 to the adders 66 to 68 of the first recursive-organization encoder 31 and the interleaved data $u_{1t}$ to the adders 65, 67, 68, and 69 of the second recursive-organization encoder 34.

Thus, when using the encoder shown in Fig. 1(a), it is possible to improve the error correction capacity for burst like data errors and moreover, uniform estimation accuracies of the transmission data $u_1$ and $u_2$ at the reception side by replacing inputs of the series of the transmission data $u_1$ with inputs of the series of the transmission data $u_2$ between the first recursive-organization convolution encoders 31 and the second recursive-organization convolution encoder 34.

Fig. 6 is an illustration showing a recursive-organization convolution encoder constituting the same code as the recursive-organization convolution encoder in Fig. 5(b). Therefore, it is possible to obtain the same advantage as the above also when replacing the recursive-organization convolution encoder shown in Fig. 5(b) with the circuit configuration in Fig. 6.

In the case of the recursive-organization convolution encoder shown in Fig. 6, reference numerals 71, 72, 73, and 74 denote delay units and reference numerals 75, 76, 77, and 78 denote adders. In the case of the recursive-organization convolution encoder, the first-stage adder 75 adds and outputs input transmission data $u_1$ (or data $u_{2t}$) and an output of the delay unit 71, the second-stage adder 76 adds and outputs input transmission data $u_1$ (or data $u_{2t}$), transmission data $u_2$ (or data $u_{1t}$), and an output of the delay unit 72, the third-stage adder 77 adds and outputs input transmission data $u_1$ (or data $u_{2t}$), an output of the delay unit 73, and an a returned output of the delay unit 74, and the final-stage adder 78 adds input transmission data $u_2$ (or data $u_{1t}$) and an output of the delay unit 74 and finally outputs redundant data $u_a$ (redundant data $u_b$).

Operations of the decoder shown in Fig. 1(b) are described below. In the case of this embodiment, a case is described in which the 16-QAM system is used for quadrature amplitude modulation (QAM). Moreover, the decoder of this embodiment estimates original transmission data by turbo-decoding low-order two bits of reception data, estimating the original transmission data through soft determination, and hard-determining other high-order bits by the third determiner 22. However reception signals Lcy: $y_4$, $y_3$, $y_2$, $y_1$, $y_a$, and $y_b$ are signals influencing outputs $u_4$, $u_3$, $u_2$, $u_1$ $u_a$, and $u_b$ of the above transmission side with noises and fading of a transmission line.

First, in the case of the turbo encoder receiving the reception signals Lcy: $y_2$, $y_1$, $y_a$, and $y_b$, the first decoder 11 extracts the reception signals Lcy: $y_2$, $y_1$, and $y_a$ and calculates logarithmic likelihood ratios L ($u_{1k}$') and L ($u_{2k}$') (where k denotes time) of information bits (corresponding to original transmission data $u_{1k}$ and $u_{2k}$) $u_{1k}$' and $u_{2k}$' estimated in accordance with these reception signals. That is, in this case, the probability that $u_{2k}$ is equal to 1 to the probability that $u_{2k}$ is equal to 0 and the probability that $u_{1k}$ is equal to 1 to the probability that $u_{1k}$ is equal to 0 are obtained. In the subsequent description, $u_{1k}$ and $u_{2k}$ are merely referred to as $u_k$ and $u_{1k}$' and $u_{2k}$' are merely referred to as $u_k$'.

In Fig. 1(b), Le ($u_k$) denotes external information and La ($u_k$) denotes advance information that is the last external information. A decoder for calculating a logarithmic likelihood ratio frequently uses a known maximum post-probability decoder (MAP algorithm: Maximum A-Posteriori). For example, it is permitted to use a known Viterbi decoder.

The adder 12 calculates the external information Le($u_k$) for the second decoder 15 in accordance with the logarithmic likelihood ratio that is the above calculation result. However, in the case of the first-time decoding, La ($u_k$) is equal to 0 because advance information is not obtained.

The interleavers 13 and 14 rearrange signals for the reception signals Lcy and external information Le($u_k$). Then, the second decoder 15 calculates the logarithmic likelihood ratio L($u_k$') in accordance with the reception signals Lcy and previously-calculated advance information La($u_k$) similarly to the case of the first decoder 11.

Thereafter, the adder 16 calculates the external information Le ($u_k$) similarly to the case of the adder 12. In this case, the external information rearranged by the deinterleave 17 is returned to the first decoder 11 as the advance information La($u_k$).

The turbo decoder calculates a more-accurate logarithmic likelihood ratio by repeatedly executing the above processing up to a predetermined number of times (number of iterations) and the first determiner 18 and the second determiner 20 determine signals in accordance with the logarithmic likelihood ratio to estimate original transmission data. Specifically, the determiners 18 and 20 determine an estimated information bit $u_k$' as 1 when a logarithmic likelihood ratio L($u_k$') is larger than 0 and the bit $u_k$' as 0 when the ratio L($u_k$') is equal to or less than 0. Moreover, simultaneously-received reception signals Lcy: y3, y4,... are hard-determined by the third determiner 22.

Finally, the first R/S decoder 19 and second R/S decoder 21 perform error check using a reed-Solomon code in accordance with a predetermined method and complete the above repetitive processing when they determine that an estimated accuracy exceeds a certain criterion. The errors in the estimated original transmission data are correct by each of determiners in accordance with a read-Solomon code to output more-accurate transmission data.

In this case, an original-transmission-data estimation method by the first R/S decoder 19 and second R/S decoder 21 is described below in accordance with examples. In this case, three methods are described as examples. In the case of the first method, whenever original transmission data is estimated by the first determiner 18 or second determiner 20, the corresponding first R/S decoder 19 or second R/S decoder 21 alternately checks errors. When either of the decoders 19 and 21 determines that there is no error, the above repetitive processing by the turbo encoder is completed and errors in the above estimated original transmission data are corrected by using a read-Solomon code to output more-accurate transmission data.

In the case of the second method, whenever original transmission data is estimated by the first determiner 18 or second determiner 20, the corresponding first R/S decoder 19 or second R/S decoder 21 alternately checks errors. When the both R/S decoders determine that there is no error, they complete the above repetitive processing performed by the turbo encoder, correct errors in the above estimated original transmission data by using a read-Solomon code, and output more-accurate transmission data.

In the case of the third method, a problem is solved that erroneous correction is performed when it is erroneously determined by the above first and second methods that there is no error and repetitive processing is not executed. For example, repetitive processing is executed by a predetermined number of times to reduce a bit error rate to a certain extent and then, errors in the above estimated original transmission data are corrected by using a read-Solomon code to output more-accurate transmission data.

Thus, when using the decoder shown in Fig. 1(b), it is possible to reduce soft determinations requiring many calculations and realize a preferable transmission characteristic by using a turbo decoder for performing soft-determination of low-order two bits of a reception signal which may be deteriorated in characteristics and error correction with a reed-Solomon code and a determiner for hard-determining other bits of the reception signal.

Moreover, by estimating transmission data with the first R/S decoder 19 and second R/S decoder 21, it is possible to reduce the number of iterations and further reduce the number of soft determinations requiring many calculations and the soft-determination period. In the case of a transmission line including random errors and burst errors, it is generally known that a superior characteristic is obtained by using a R-S code (reed-Solomon) for correcting errors in symbols and other known error correction code together.

The BER (bit error rate) characteristic when decoding transmission data by a turbo encoder of the present invention is compared with the BER characteristic when decoding transmission data by a conventional turbo encoder. Fig. 7 is an illustration showing the both BER characteristics. For example, when determining the performance of a turbo code by using a BER, a turbo-encoded minimum hamming weight $W_{min}$ influences a high-SNR BER. That is, it is generally known that when a minimum hamming weight is small, the BER of an error floor area (area in which drop of BER becomes moderate) rises. Thus, it is found that the minimum hamming weight $W_{min}$ most influences the BER characteristic in a high $E_b/N_o$ area, that is, an error floor area. Therefore, in this case, a minimum hamming weight according to a turbo code word is used as an index for comparing performances of encoders.

Fig. 8 is an illustration showing the minimum hamming weight of a turbo encoder of the present invention and that of a conventional turbo encoder when using a certain interleaver. These minimum hamming weights are minimum values of hamming weights '2' and '3' of input information bit series turbo-encoded for all patterns.

From a result of comparison and study in Figs. 7 and 8, it is found that the performance of the turbo encoder shown in Fig. 1 having a large minimum hamming weight and a low BER characteristic of an error floor area is clearly superior to that of the conventional case.

Thus, by applying the type of inputting either series of transmission data to the final-stage adder as shown in Fig. 5(b) and Fig. 6 to a recursive-organization convolution encoder used for the turbo encoder 1, it is possible to more strongly reflect the influence of the transmission data on redundant data. That is, it is possible to greatly improve the demodulation characteristic at the reception side compared to the case of the conventional case.

In the above description, the demodulation characteristic at the reception side is improved in accordance with the difference between recursive-organization convolution encoders by assuming that a conventional turbo encoder and the turbo encoder shown in Fig. 1 use the same interleaver. In the subsequent description, however, the demodulation characteristic is greatly improved by using the interleaver of this embodiment to obtain an optimum transmission characteristic close to the Shannon limit, that is, an optimum BER characteristic.

Fig. 9, Fig. 10, and Fig. 11 are illustrations showing processings by the first embodiment of the interleavers 32 and 33 used for the turbo encoder shown in Fig. 5(a). In this case, the processing for replacing information bit series at random by the interleavers 32 and 33 of this embodiment is described below.

For example, in the case of W-CDMA, a PIL is generally used as an interleaver. However, a parallel prime interleaver (hereafter referred to as PPI) serving as an interleaver is used for the present invention instead of the PIL. The PPI has the following three features.

1. Replacing rows and columns of N(ordinate axis: natural number)$\times$M(abscissa axis: natural number) buffers.
2. Shifting a mapping pattern every $\{g_0 \times c(i-1)\}$modP in rows.
3. Avoiding a critical pattern by replacing rows.

Operations of the PPI serving as the interleaver of this embodiment are described below. In the case of this embodiment, rearrangement is performed in the same condition as the case of the interleaver described in Prior Art in order to accurately evaluate performances. Specifically, a mapping pattern c is generated by assuming interleaver length $L_{turbo}$ = 512 bits, N = 10, M = P = 53 ($L_{turbo}/N \leq P+1$), and primitive root go = 2 in accordance with the above expression (1).

As a result, the mapping pattern C is shown as {1, 2, 4, 8, 16, 32, 11, 22, 44, 35, 17, 34, 15, 30, 7, 14, 28, 3, 6, 12, 24, 48, 43, 33, 13, 26, 52, 51, 49, 45, 37, 21, 42, 31, 9, 18, 36, 19, 38, 23, 46, 39, 25, 50, 47, 41, 29, 5, 10, 20, 40, 27}.

Moreover, in the case of the PPI, bits are replaced by shifting the above mapping pattern C every $\{g_0 \times c (i-1)\}$ modP in rows, that is, every 1, 2, 4, 8, 16, 32, 11, 22, and 44 in rows to generate a mapping pattern $C_j$ of j rows. Fig. 9 is an illustration showing the mapping pattern $C_j$ rearranged by the above method. In this case, it is assumed that j ranges between 0 and N-1.

Fig. 10 is an illustration showing data arrangement when mapping data of interleaver length $L_{turbo}$ = 512 bits on the above rearranged mapping pattern. In this case, data {0-52} is mapped on the first row, data {53-105 is mapped on the second row, data {106-158} is mapped on the third row, data {159-211} is mapped on the fourth row, data {212-264} is mapped on the fifth row, data {265-317} is mapped on the sixth row, data {318-370} is mapped on the seventh row, data {371-423} is mapped on the eighth row, data {424-476} is mapped on the ninth row, and data {477-529} is mapped on the tenth row.

Finally, Fig. 11 is an illustration showing a final rearrangement pattern. In this case, rows in the data arrangement in Fig. 10 are replaced in accordance with a predetermine rule to generate the final rearrangement pattern. In the case of this embodiment, the sequence of rows in the data arrangement in Fig. 10 is reversed. Moreover, the PPI reads the generated rearrangement pattern in columns, that is, vertically.

Fig. 12 is an illustration quantitatively comparing the PPI of this embodiment with a conventional PIL. In this case, the minimum inter-signal point distance (1, x) points denotes the minimum inter-signal-point distance of adjacent rows in an N $\times$ M buffer and the minimum inter-signal-point distance (2, x) denotes the minimum inter-signal-point distance with the data two values forward or two values backward in the arrangement of interleaved data finally read in order vertically starting with the leftmost column in an N $\times$ M buffer and connected in series. Subsequently, up to the minimum inter-signal-point distance with the data 9 values forward or 9 values backward is described in order. Moreover, Variance (or shown as Normalized dispersion) is used as an index showing randomness, in which 1 is maximum (100% random).

Thus, in the case of this embodiment, it is possible to improve the randomness while keeping the inter-signal-point distance same as ever by using a PPI of the present invention as an interleaver. Therefore, it is possible to improve an error correction capacity. Thereby, because the demodulation characteristic at the reception side can be greatly improve, it is possible to obtain an optimum transmission characteristic close to the Shannon limit, that is, an optimum BER characteristic.

In the case of this embodiment, rearrangement is performed under the same condition as the conventional case. However, because each of the parameters including an interleave length are optional, they can be properly changed.

Second Embodiment:

Fig. 13, Fig. 14, and Fig. 15 are illustrations showing processings by the second embodiment of interleavers 32 and 33 used for the turbo encoder shown in Fig. 5(a). In this case, the processing for replacing information bit series at random by using the interleavers 32 and 33 of this embodiment is described below. Configurations other than interleavers are the same as the case of the first embodiment, they are provided with the same symbols and their descriptions are omitted.

The PPI of this embodiment has the following three features.

1. Replacing rows and columns in N (ordinate axis: natural number) $\times$ M (abscissa axis: natural number) buffers.
2. Shifting a mapping pattern leftward in rows one column by one column.
3. Avoiding a critical pattern by replacing rows.

Operations of the PPI serving as the interleaver of this embodiment are described below. In the case of this embodiment, rearrangement is performed under the same condition as the case of the interleaver described in Prior Art in order to accurately evaluate performances. Specifically, a mapping pattern c is generated in accordance with the above expression (1) by assuming interleaver length $L_{turbo}$=512 bits, N=10, M=P=53 ($L_{turbo}/N \leq P+1$), and primitive root go=2.

As a result, the mapping pattern C is shown as {1, 2, 4, 8, 16, 32, 11, 22, 44, 35, 17, 34, 15, 30, 7, 14, 28, 3, 6, 12, 24, 48, 43, 33, 13, 26, 52, 51, 49, 45, 37, 21, 42, 31, 9, 18, 36, 19, 38, 23, 46, 39, 25, 50, 47, 41, 29, 5, 10, 20, 40, 27}.

Moreover, a mapping pattern $C_j$ of j rows is generated by shifting the mapping pattern C in rows one column by one column and thereby replacing bits. Fig. 13 is an illustration showing the mapping pattern $C_j$ rearranged by the above method. In this case, it is assumed that j ranges between 0 and N-1.

Fig. 14 is an illustration showing the data arrangement when mapping data of the interleaver length $L_{turbo}$=512 bits on the above rearranged mapping pattern. In this case,, data {0-52} is mapped on the first row, data {53-105} is mapped on the second row, data {106-158} is mapped on the third row, data {159-211} is mapped on the fourth row, data {212-264} is mapped on the fifth row, data {265-317} is mapped on the sixth row, data {318-370} is mapped on the seventh row, data {371-423} is mapped on the eighth row, data {424-476} is mapped on the ninth row, and data {477-529} is mapped on the tenth row.

Fig. 15 is an illustration showing a final rearrangement pattern. In this case, rows in the data arrangement in Fig. 14 are replaced in accordance with a predetermined rule to generate the final rearrangement pattern. In the case of this embodiment, the sequence of rows in the data arrangement in Fig. 14 is reversed. Moreover, the PPI reads the generated rearrangement pattern in columns, that is, vertically.

Fig. 16 is an illustration quantitatively comparing the PPI of this embodiment with a conventional PIL. In this case, theminimuminter-signal-pointdistance (1, x) denotes the minimum inter-signal-point distance of adjacent rows in an N xM buffer and the minimum inter-signal-point distance (2,x) denotes the minimum inter-signal-point distance with the data two values forward or two values backward in the arrangement of interleaved data finally read in order vertically starting with the leftmost column in an N × M buffer and connected in series. Subsequently, up to the minimum inter-signal-point distance with the data 9 values forward or 9 values backward is described in order. Moreover, Variance (or shown as Normalized dispersion) is used as an index showing randomness, in which 1 is maximum (100% random).

Thus, in the case of this embodiment, it is possible to greatly improve an inter-signal-point distance compared to a conventional case. Therefore, it is possible to further improve an error correction capacity in accordance with the combination with a convolution encoder. Thereby, because it is possible to further greatly improve the demodulation characteristic at the reception side, it is possible to obtain an optimum transmission characteristic close to the Shannon limit, that is, an optimum BER characteristic.

Third Embodiment:

When using the turbo encoder shown in Fig. 5(a), if the interleaver 32 is the same as the interleaver 33, the inter-signal-point distance becomes 0. Therefore, for example, when one output is influenced by noises, the other output is also influenced. Therefore, this embodiment provides an interleaver most suitable for the turbo encoder having two information bit series shown in Fig. 5(a), that is, an interleaver capable of taking a sufficient inter-signal-point distance between information bit series.

Operations of the interleave of the first embodiment are described below by using the interleaver of the first embodiment. For example, in the case of this embodiment, rearrangement is performed so that inter-signal-point distances of two information bit series do not become 0. Specifically, information bit series U1 are arranged in order of first row, second row, third row,..., and tenth row of an N × M buffer in the interleaver 32 and information bit series U2 are arranged in order of fifth row, sixth row, seventh row,..., and fourth row of the N × M buffer in the interleaver 33. After rearrangement same as the case of the first embodiment is completed, data series arranged in N×M buffers in the both interleavers are vertically read in order starting with the first column of the first row.

Fig. 17 is an illustration showing the inter-signal-point distance between the information bit series U1 and information bit series U2 when assuming the distance between U1 and U2 as five rows. Moreover, in the case of this embodiment, all inter-signal-point distances are obtained not only when assuming the distance between U1 and U2 as five rows but also when assuming the distance between U1 and U2 as one to nine rows. Then, in the case of this embodiment, rearrangement is performed by using two interleavers having the distance between U1 and U2 from which an optimum transmission characteristic is obtained out of the inter-signal-point distances.

Fig. 18 is an illustration showing optimum values of two interleavers when rearrangement is performed under the same condition as the case of the first embodiment. In this case, an optimum transmission characteristic is obtained when the distance between information bit series U1 and information bit series U2 is equal to nine rows.

Thus, in the case of this embodiment, an interleaver from which an optimum transmission characteristic is obtained is selected by obtaining all distances between the information bit series U1 and information bit series U2 and moreover obtaining the inter-signal-point distance for each of the distances. Thereby, it is possible to realize an interleaver most suitable for the turbo encoder having two information bit series shown in Fig. 5(a), that is, an interleaver capable of taking a sufficient inter-signal-point distance between information bit series.

Though this embodiment uses the first embodiment for convenience's sake of description, it is also possible to apply this embodiment to the interleaver of the second embodiment. Moreover, it is possible to apply this embodiment to a turbo encoder having two other information bit series.

Furthermore, in the case of this embodiment, two information bit series are arranged to different rows of an N × M buffer in the interleaver 32. However, it is also permitted to arrange two information bit series to the same position of an N × M buffer in the interleaver 32 and shift the rearranged read start position.

As described above, according to one aspect of the present invention, it is possible to improve the randomness while keeping the inter-signal-point distance same as ever by using random series and thereby using rearrangement unit which rearranges bits in rows. Therefore, it is possible to improve an error correction capacity. Thereby, an advantage is obtained that because the demodulation characteristic at the reception side can be greatly improved, it is possible to obtain a communication apparatus capable of realizing an optimum transmission characteristic close to the Shannon limit, that is, an optimum BER characteristic.

According to another aspect of the present invention, it is possible to greatly improve an inter-signal-point distance compared to a conventional case by using rearrangement unit which shifts a random series one column by one column in rows. Therefore, it is possible to improve an error correction capacity in accordance with the combination with a convolution encoder. Thereby, because the demodulation characteristic at the reception side can be greatly improved, an advantage is obtained that it is possible to obtain a communication apparatus capable of realizing an optimum transmission characteristic close to the Shannon limit, that is, an optimum BER characteristic.

According to still another aspect of the present invention, a rearrangement unit capable of obtaining an optimum transmission characteristic is selected by obtaining all distances between information bit series U1 and information bit series U2 and moreover obtaining the inter-signal distance for each of the distances. Thereby, an advantage is obtained that it is possible to obtain a communication apparatus capable of realizing rearrangement unit most suitable for a turbo encoder having two information bit series, that is, rearrangement unit capable of taking a sufficient inter-signal-point distance between information bit series.

According to still another aspect of the present invention, it is possible to improve randomness while keeping the inter-signal-point distance same as ever by using a random series and thereby using a random-series generation step of rearranging bits in rows. Therefore, it is possible to improve an error correction capacity. Thereby, because it is possible to greatly improve the demodulation characteristic at the reception side, an advantage is obtained that it is possible to obtain a communication method capable of realizing an optimum transmission characteristic close to the Shannon limit, that is, an optimum BER characteristic.

According to still another aspect of the present invention, it is possible greatly improve an inter-signal-point distance compared to a conventional case by using a random-series generation step of shifting a random series one column by one column in rows. Therefore, it is possible to further improve an error correction capacity in accordance with the combination with a convolution encoder. Thereby, because the demodulation characteristic at the reception side can be greatly improve, an advantage is obtained that it is possible to obtain a communication method capable of realizing an optimum transmission characteristic close to the Shannon limit, that is, an optimum BER characteristic.

According to still another aspect of the present invention, for example an interleaver from which an optimum transmission characteristic can be obtained is selected by obtaining all distances between information bit series U1 and information bit series U2 and moreover obtaining the inter-signal distance for each of the distances. Thereby, an advantage is obtained that it is possible to obtain a communication method capable of realizing optimum rearrangement for the turbo encoder having tow information bit series, that is, rearrangement capable of taking a sufficient inter-signal-point distance between information bit series.

INDUSTRIAL APPLICABILITY

As described above, a communication apparatus and a communication method of the present invention are useful for data communication using an existing communication line in accordance with the DMT (Discrete Multi Tone) modulation system or OFDM (Orthogonal Frequency Division Multiplex) modulation system and suitable for all communications using the multicarrier modulation/demodulation system and single-carrier modulation/demodulation system.

**Claims**

1. An interleaver that performs interleaving with respect to a first data series including a plurality of data arranged in a first arrangement sequence and that generates a second data series including said plurality of data arranged in a second arrangement sequence, wherein:

   (A) a series including X elements wherein X depends on the number of said plurality of data, the elements being expressed using arrangement sequence numbers according to the first arrangement sequence, and being arranged in the second arrangement sequence is defined as a mapping series, wherein

1) said mapping series includes Z first sub-mapping series that are obtained by partitioning the mapping series per Y elements of the X elements into the Z first sub-mapping series,
2) X, Y and Z are natural numbers, and X is a product of Z and Y,
3) said mapping series includes Y second sub-mapping series, wherein each of the second sub-mapping series includes Z elements that are arranged at a same arrangement sequence number as in the Z first sub-mapping series, and
4) a particular one of the second sub-mapping series which includes a particular element is defined as a basic series, and,

(B) each second sub-mapping series except the basic series is equivalent to one of series which are each obtained based on addition of a predetermined number that is different among the second sub-mapping series to each element of the basic series that have been expressed using the arrangement sequence numbers according to the first arrangement sequence, and based on cyclic shift of a series which is obtained as a result of this addition.

2. An interleaver according to claim 1, wherein the particular element included in the basic series is corresponding to a leading arrangement sequence number of the first arrangement sequence.

3. An interleaving method including step of performing interleaving with respect to a first data series including a plurality of data arranged in a first arrangement sequence and generating a second data series including said plurality of data arranged in a second arrangement sequence, wherein:

(A) a series including X elements, wherein X depends on the number of said plurality of data, the elements being expressed using arrangement sequence numbers according to the first arrangement sequence, and being arranged in the second arrangement sequence is defined as a mapping series, wherein

1) said mapping series includes Z first sub-mapping series that are obtained by partitioning the mapping series per Y elements of the X elements into the Z first sub-mapping series,
2) X, Y and Z are natural numbers, and X is a product of Z and Y,
3) said mapping series includes Y second sub-mapping series, wherein each of the second sub-mapping series includes Z elements that are arranged at a same arrangement sequence number as in the Z first sub-mapping series, and
4) a particular one of the second sub-mapping series which includes a particular element is defined as a basic series, and,

(B) each second sub-mapping series except the basic series is equivalent to one of series which are each obtained based on addition of a predetermined number that is different among the second sub-mapping series to each element of the basic series that have been expressed using the arrangement sequence numbers according to the first arrangement sequence, and based on cyclic shift of a series which is obtained as a result of this addition.

4. An interleaving method according to claim 3, wherein the particular element included in the basic series is corresponding to a leading arrangement sequence number of the first arrangement sequence.

# FIG.1

(a)

(b)

# FIG.2

# FIG.3

# FIG.4

(a)

(b)

(c)

# FIG.5

(a)

(b)

# FIG.6

$U_2(U_{1t})$

$U_1(U_{2t})$

71 72 73 74

D  ⊕  D  ⊕  D  ⊕  D  ⊕ → $U_a(U_b)$

75 76 77 78

# FIG.7

CONVENTIONAL ENCODER
(MINIMUM HAMMING
WEIGHT: SMALL)

PROPOSED ENCODER
(MINIMUM HAMMING
WEIGHT: LARGE)

WATERFALL AREA

ERROR FLOOR AREA

BER DIFFERENCE

BIT ERROR PROBABILITY

1.0E-00
1.0E-01
1.0E-02
1.0E-03
1.0E-04
1.0E-05
1.0E-06
1.0E-07
1.0E-08

9    10    11    12

Eb/No

# FIG.8

| INTERLEAVER SIZE (BIT) | CONVENTIONAL ENCODER | PROPOSED ENCODER |
|---|---|---|
| 128 | 10 | 11 |
| 256 | 10 | 11 |
| 512 | 10 | 12 |

**FIG.9**

| M\N | 1 | 2 | 3 | 4 | 5 | 6 | 7 | 8 | 9 | 10 | 11 | 12 | 13 | 14 | 15 | 16 | 17 | 18 | 19 | 20 |
|---|---|---|---|---|---|---|---|---|---|---|---|---|---|---|---|---|---|---|---|---|
| 1 | 1 | 2 | 4 | 8 | 16 | 32 | 11 | 22 | 44 | 35 | 17 | 34 | 15 | 30 | 7 | 14 | 28 | 3 | 6 | 12 |
| 2 | 2 | 4 | 8 | 16 | 32 | 11 | 22 | 44 | 35 | 17 | 34 | 15 | 30 | 7 | 14 | 28 | 3 | 6 | 12 | 24 |
| 3 | 8 | 16 | 32 | 11 | 22 | 44 | 35 | 17 | 34 | 15 | 30 | 7 | 14 | 28 | 3 | 6 | 12 | 24 | 48 | 43 |
| 4 | 22 | 44 | 35 | 17 | 34 | 15 | 30 | 7 | 14 | 28 | 3 | 6 | 12 | 24 | 48 | 43 | 33 | 13 | 26 | 52 |
| 5 | 14 | 28 | 3 | 6 | 12 | 24 | 48 | 43 | 33 | 13 | 26 | 52 | 51 | 49 | 45 | 37 | 21 | 42 | 31 | 9 |
| 6 | 21 | 42 | 31 | 9 | 18 | 36 | 19 | 38 | 23 | 46 | 39 | 25 | 50 | 47 | 41 | 29 | 5 | 10 | 20 | 40 |
| 7 | 17 | 34 | 15 | 30 | 7 | 14 | 28 | 3 | 6 | 12 | 24 | 48 | 43 | 33 | 13 | 26 | 52 | 51 | 49 | 45 |
| 8 | 48 | 43 | 33 | 13 | 26 | 52 | 51 | 49 | 45 | 37 | 21 | 42 | 31 | 9 | 18 | 36 | 19 | 38 | 23 | 46 |
| 9 | 50 | 47 | 41 | 29 | 5 | 10 | 20 | 40 | 27 | 1 | 2 | 4 | 8 | 16 | 32 | 11 | 22 | 44 | 35 | 17 |
| 10 | 9 | 18 | 36 | 19 | 38 | 23 | 46 | 39 | 25 | 50 | 47 | 41 | 29 | 5 | 10 | 20 | 40 | 27 | 1 | 2 |

| M\N | 21 | 22 | 23 | 24 | 25 | 26 | 27 | 28 | 29 | 30 | 31 | 32 | 33 | 34 | 35 | 36 | 37 | 38 | 39 | 40 |
|---|---|---|---|---|---|---|---|---|---|---|---|---|---|---|---|---|---|---|---|---|
| 1 | 24 | 48 | 43 | 33 | 13 | 26 | 52 | 51 | 49 | 45 | 37 | 21 | 42 | 31 | 9 | 18 | 36 | 19 | 38 | 23 |
| 2 | 48 | 43 | 33 | 13 | 26 | 52 | 51 | 49 | 45 | 37 | 21 | 42 | 31 | 9 | 18 | 36 | 19 | 38 | 23 | 46 |
| 3 | 33 | 13 | 26 | 52 | 51 | 49 | 45 | 37 | 21 | 42 | 31 | 9 | 18 | 36 | 19 | 38 | 23 | 46 | 39 | 25 |
| 4 | 51 | 49 | 45 | 37 | 21 | 42 | 31 | 9 | 18 | 36 | 19 | 38 | 23 | 46 | 39 | 25 | 50 | 47 | 41 | 29 |
| 5 | 18 | 36 | 19 | 38 | 23 | 46 | 39 | 25 | 50 | 47 | 41 | 29 | 5 | 10 | 20 | 40 | 27 | 1 | 2 | 4 |
| 6 | 27 | 1 | 2 | 4 | 8 | 16 | 32 | 11 | 22 | 44 | 35 | 17 | 34 | 15 | 30 | 7 | 14 | 28 | 3 | 6 |
| 7 | 37 | 21 | 42 | 31 | 9 | 18 | 36 | 19 | 38 | 23 | 46 | 39 | 25 | 50 | 47 | 41 | 29 | 5 | 10 | 20 |
| 8 | 39 | 25 | 50 | 47 | 41 | 29 | 5 | 10 | 20 | 40 | 27 | 1 | 2 | 4 | 8 | 16 | 32 | 11 | 22 | 44 |
| 9 | 34 | 15 | 30 | 7 | 14 | 28 | 3 | 6 | 12 | 24 | 48 | 43 | 33 | 13 | 26 | 52 | 51 | 49 | 45 | 37 |
| 10 | 4 | 8 | 16 | 32 | 11 | 22 | 44 | 35 | 17 | 34 | 15 | 30 | 7 | 14 | 28 | 3 | 6 | 12 | 24 | 48 |

| M\N | 41 | 42 | 43 | 44 | 45 | 46 | 47 | 48 | 49 | 50 | 51 | 52 | 53 |
|---|---|---|---|---|---|---|---|---|---|---|---|---|---|
| 1 | 46 | 39 | 25 | 50 | 47 | 41 | 29 | 5 | 10 | 20 | 40 | 27 | 0 |
| 2 | 39 | 25 | 50 | 47 | 41 | 29 | 5 | 10 | 20 | 40 | 27 | 1 | 0 |
| 3 | 50 | 47 | 41 | 29 | 5 | 10 | 20 | 40 | 27 | 1 | 2 | 4 | 0 |
| 4 | 5 | 10 | 20 | 40 | 27 | 1 | 2 | 4 | 8 | 16 | 32 | 11 | 0 |
| 5 | 8 | 16 | 32 | 11 | 22 | 44 | 35 | 17 | 34 | 15 | 30 | 7 | 0 |
| 6 | 12 | 24 | 48 | 43 | 33 | 13 | 26 | 52 | 51 | 49 | 45 | 37 | 0 |
| 7 | 40 | 27 | 1 | 2 | 4 | 8 | 16 | 32 | 11 | 22 | 44 | 35 | 0 |
| 8 | 35 | 17 | 34 | 15 | 30 | 7 | 14 | 28 | 3 | 6 | 12 | 24 | 0 |
| 9 | 21 | 42 | 31 | 9 | 18 | 36 | 19 | 38 | 23 | 46 | 39 | 25 | 0 |
| 10 | 43 | 33 | 13 | 26 | 52 | 51 | 49 | 45 | 37 | 21 | 42 | 31 | 0 |

21

| N\M | 1 | 2 | 3 | 4 | 5 | 6 | 7 | 8 | 9 | 10 | 11 | 12 | 13 | 14 | 15 | 16 | 17 | 18 | 19 | 20 |
|---|---|---|---|---|---|---|---|---|---|---|---|---|---|---|---|---|---|---|---|---|
| 1 | 1 | 2 | 4 | 8 | 16 | 32 | 11 | 22 | 44 | 35 | 17 | 34 | 15 | 30 | 7 | 14 | 28 | 3 | 6 | 12 |
| 2 | 55 | 57 | 61 | 69 | 85 | 64 | 75 | 97 | 88 | 70 | 87 | 68 | 83 | 60 | 67 | 61 | 56 | 59 | 65 | 77 |
| 3 | 114 | 112 | 138 | 117 | 128 | 150 | 141 | 123 | 140 | 121 | 136 | 113 | 120 | 134 | 109 | 112 | 118 | 130 | 154 | 149 |
| 4 | 181 | 203 | 194 | 176 | 193 | 174 | 189 | 166 | 173 | 187 | 162 | 165 | 171 | 183 | 207 | 202 | 192 | 172 | 185 | 211 |
| 5 | 226 | 240 | 215 | 218 | 224 | 236 | 260 | 255 | 245 | 225 | 238 | 264 | 263 | 261 | 257 | 249 | 233 | 254 | 243 | 221 |
| 6 | 286 | 307 | 296 | 274 | 283 | 301 | 284 | 303 | 288 | 311 | 304 | 290 | 315 | 312 | 306 | 294 | 270 | 275 | 285 | 305 |
| 7 | 335 | 352 | 333 | 348 | 325 | 332 | 346 | 321 | 324 | 330 | 342 | 366 | 361 | 351 | 331 | 344 | 370 | 369 | 367 | 363 |
| 8 | 419 | 414 | 404 | 384 | 397 | 423 | 422 | 420 | 416 | 408 | 392 | 413 | 402 | 380 | 389 | 407 | 390 | 409 | 394 | 417 |
| 9 | 474 | 471 | 465 | 453 | 429 | 434 | 444 | 464 | 451 | 425 | 426 | 428 | 432 | 440 | 456 | 435 | 446 | 468 | 459 | 441 |
| 10 | 486 | 495 | 513 | 496 | 515 | 500 | 523 | 516 | 502 | 527 | 524 | 518 | 506 | 482 | 487 | 497 | 517 | 504 | 478 | 479 |

| N\M | 21 | 22 | 23 | 24 | 25 | 26 | 27 | 28 | 29 | 30 | 31 | 32 | 33 | 34 | 35 | 36 | 37 | 38 | 39 | 40 |
|---|---|---|---|---|---|---|---|---|---|---|---|---|---|---|---|---|---|---|---|---|
| 1 | 24 | 48 | 43 | 33 | 13 | 26 | 52 | 51 | 49 | 45 | 37 | 21 | 42 | 31 | 9 | 18 | 36 | 19 | 38 | 23 |
| 2 | 101 | 96 | 86 | 66 | 79 | 105 | 104 | 102 | 98 | 90 | 74 | 95 | 84 | 62 | 71 | 89 | 72 | 91 | 76 | 99 |
| 3 | 139 | 119 | 132 | 158 | 157 | 155 | 151 | 143 | 127 | 148 | 137 | 115 | 124 | 142 | 125 | 144 | 129 | 152 | 145 | 131 |
| 4 | 210 | 208 | 204 | 196 | 180 | 201 | 190 | 168 | 177 | 195 | 178 | 197 | 182 | 205 | 198 | 184 | 209 | 206 | 200 | 188 |
| 5 | 230 | 248 | 231 | 250 | 235 | 258 | 251 | 237 | 262 | 259 | 253 | 241 | 217 | 222 | 232 | 252 | 239 | 213 | 214 | 216 |
| 6 | 292 | 266 | 267 | 269 | 273 | 281 | 297 | 276 | 287 | 309 | 300 | 282 | 299 | 280 | 295 | 272 | 279 | 293 | 268 | 271 |
| 7 | 355 | 339 | 360 | 349 | 327 | 336 | 354 | 337 | 356 | 341 | 364 | 357 | 343 | 368 | 365 | 359 | 347 | 323 | 328 | 338 |
| 8 | 410 | 396 | 421 | 418 | 412 | 400 | 376 | 381 | 391 | 411 | 398 | 372 | 373 | 375 | 379 | 387 | 403 | 382 | 393 | 415 |
| 9 | 485 | 439 | 454 | 431 | 438 | 452 | 427 | 430 | 436 | 448 | 472 | 467 | 457 | 437 | 450 | 476 | 475 | 473 | 469 | 461 |
| 10 | 481 | 485 | 493 | 509 | 488 | 499 | 521 | 512 | 494 | 511 | 492 | 507 | 484 | 491 | 505 | 480 | 483 | 489 | 501 | 525 |

| N\M | 41 | 42 | 43 | 44 | 45 | 46 | 47 | 48 | 49 | 50 | 51 | 52 | 53 |
|---|---|---|---|---|---|---|---|---|---|---|---|---|---|
| 1 | 46 | 39 | 25 | 50 | 47 | 41 | 29 | 5 | 10 | 20 | 40 | 27 | 0 |
| 2 | 92 | 78 | 103 | 100 | 94 | 92 | 58 | 63 | 73 | 93 | 80 | 54 | 53 |
| 3 | 156 | 153 | 147 | 135 | 111 | 116 | 126 | 146 | 133 | 107 | 108 | 110 | 106 |
| 4 | 164 | 169 | 179 | 199 | 186 | 160 | 161 | 163 | 167 | 175 | 191 | 170 | 159 |
| 5 | 220 | 228 | 244 | 223 | 234 | 256 | 247 | 229 | 246 | 227 | 242 | 219 | 212 |
| 6 | 277 | 289 | 313 | 308 | 298 | 278 | 291 | 317 | 316 | 314 | 310 | 302 | 265 |
| 7 | 358 | 345 | 319 | 320 | 322 | 326 | 334 | 350 | 329 | 340 | 362 | 353 | 318 |
| 8 | 406 | 388 | 405 | 386 | 401 | 378 | 385 | 399 | 374 | 377 | 383 | 395 | 371 |
| 9 | 445 | 466 | 455 | 433 | 442 | 460 | 443 | 462 | 447 | 470 | 463 | 449 | 424 |
| 10 | 520 | 510 | 490 | 503 | 529 | 528 | 526 | 522 | 514 | 498 | 519 | 508 | 477 |

FIG.10

EP 2 299 598 A2

| N\M | 1 | 2 | 3 | 4 | 5 | 6 | 7 | 8 | 9 | 10 | 11 | 12 | 13 | 14 | 15 | 16 | 17 | 18 | 19 | 20 |
|---|---|---|---|---|---|---|---|---|---|---|---|---|---|---|---|---|---|---|---|---|
| 1 | 486 | 495 | 513 | 496 | 515 | 500 | 523 | 516 | 502 | 527 | 524 | 519 | 506 | 482 | 487 | 497 | 517 | 504 | 478 | 479 |
| 2 | 474 | 471 | 465 | 453 | 429 | 434 | 444 | 464 | 451 | 425 | 518 | 428 | 432 | 440 | 456 | 635 | 446 | 468 | 459 | 441 |
| 3 | 419 | 414 | 404 | 384 | 397 | 432 | 422 | 420 | 416 | 408 | 392 | 413 | 402 | 380 | 389 | 407 | 390 | 409 | 394 | 417 |
| 4 | 335 | 352 | 333 | 348 | 325 | 332 | 346 | 321 | 324 | 330 | 342 | 366 | 361 | 351 | 331 | 344 | 370 | 369 | 367 | 363 |
| 5 | 286 | 307 | 296 | 274 | 283 | 301 | 284 | 303 | 288 | 311 | 304 | 290 | 315 | 312 | 306 | 294 | 270 | 375 | 285 | 305 |
| 6 | 226 | 240 | 215 | 218 | 224 | 236 | 260 | 255 | 245 | 225 | 238 | 264 | 263 | 261 | 257 | 249 | 233 | 254 | 243 | 221 |
| 7 | 181 | 203 | 194 | 176 | 193 | 174 | 189 | 166 | 173 | 187 | 162 | 165 | 171 | 183 | 207 | 202 | 192 | 172 | 185 | 211 |
| 8 | 114 | 122 | 138 | 117 | 128 | 150 | 141 | 123 | 140 | 121 | 136 | 113 | 120 | 134 | 109 | 112 | 118 | 130 | 154 | 149 |
| 9 | 55 | 57 | 61 | 69 | 85 | 64 | 75 | 97 | 88 | 70 | 87 | 68 | 83 | 60 | 67 | 81 | 56 | 59 | 65 | 77 |
| 10 | 1 | 2 | 4 | 8 | 16 | 32 | 11 | 22 | 44 | 35 | 17 | 34 | 15 | 30 | 7 | 14 | 28 | 3 | 6 | 12 |

| N\M | 21 | 22 | 23 | 24 | 25 | 26 | 27 | 28 | 29 | 30 | 31 | 32 | 33 | 34 | 35 | 36 | 37 | 38 | 39 | 40 |
|---|---|---|---|---|---|---|---|---|---|---|---|---|---|---|---|---|---|---|---|---|
| 1 | 481 | 485 | 493 | 509 | 488 | 499 | 521 | 512 | 494 | 511 | 492 | 507 | 484 | 491 | 505 | 480 | 483 | 489 | 501 | 525 |
| 2 | 458 | 439 | 454 | 431 | 438 | 452 | 427 | 430 | 436 | 448 | 472 | 467 | 457 | 437 | 450 | 476 | 475 | 473 | 469 | 461 |
| 3 | 410 | 396 | 421 | 418 | 412 | 400 | 376 | 381 | 391 | 411 | 398 | 372 | 373 | 375 | 379 | 387 | 403 | 382 | 393 | 415 |
| 4 | 355 | 339 | 360 | 349 | 327 | 336 | 354 | 337 | 356 | 341 | 364 | 357 | 343 | 368 | 365 | 359 | 347 | 323 | 328 | 338 |
| 5 | 292 | 266 | 267 | 269 | 273 | 281 | 297 | 276 | 287 | 309 | 300 | 282 | 299 | 280 | 295 | 272 | 279 | 293 | 268 | 271 |
| 6 | 230 | 248 | 231 | 250 | 235 | 258 | 251 | 237 | 262 | 259 | 253 | 241 | 217 | 222 | 232 | 252 | 239 | 213 | 214 | 216 |
| 7 | 210 | 208 | 204 | 196 | 180 | 201 | 190 | 168 | 177 | 195 | 178 | 197 | 182 | 205 | 198 | 184 | 209 | 206 | 200 | 188 |
| 8 | 139 | 119 | 132 | 158 | 157 | 155 | 151 | 143 | 127 | 148 | 137 | 115 | 124 | 142 | 125 | 144 | 129 | 152 | 145 | 131 |
| 9 | 101 | 96 | 86 | 66 | 79 | 105 | 104 | 102 | 98 | 90 | 74 | 95 | 84 | 62 | 71 | 89 | 72 | 91 | 76 | 99 |
| 10 | 24 | 48 | 43 | 33 | 13 | 26 | 52 | 51 | 49 | 45 | 37 | 21 | 42 | 31 | 9 | 18 | 36 | 19 | 38 | 23 |

| N\M | 41 | 42 | 43 | 44 | 45 | 46 | 47 | 48 | 49 | 50 | 51 | 52 | 53 |
|---|---|---|---|---|---|---|---|---|---|---|---|---|---|
| 1 | 520 | 510 | 490 | 503 | 529 | 528 | 526 | 522 | 514 | 498 | 519 | 508 | 477 |
| 2 | 445 | 466 | 455 | 433 | 442 | 460 | 443 | 462 | 447 | 470 | 463 | 449 | 424 |
| 3 | 406 | 388 | 405 | 386 | 401 | 378 | 385 | 399 | 347 | 377 | 383 | 395 | 371 |
| 4 | 358 | 345 | 319 | 320 | 322 | 326 | 334 | 350 | 329 | 340 | 362 | 353 | 318 |
| 5 | 277 | 289 | 313 | 308 | 298 | 278 | 291 | 317 | 316 | 314 | 310 | 302 | 265 |
| 6 | 220 | 223 | 244 | 223 | 234 | 256 | 247 | 229 | 246 | 227 | 242 | 219 | 212 |
| 7 | 164 | 169 | 179 | 199 | 186 | 160 | 161 | 163 | 167 | 175 | 191 | 170 | 159 |
| 8 | 156 | 153 | 147 | 135 | 111 | 116 | 126 | 146 | 133 | 107 | 108 | 110 | 106 |
| 9 | 92 | 78 | 103 | 100 | 94 | 82 | 58 | 63 | 73 | 93 | 80 | 54 | 53 |
| 10 | 46 | 39 | 25 | 50 | 47 | 41 | 29 | 5 | 10 | 20 | 40 | 27 | 0 |

FIG.11

# FIG.12

SUMMARY OF DATA

|  | PPI | PIL |
|---|---|---|
| NUMBER OF COLUM | M:53 | M:53 |
| NUMBER OF ROW | N:10 | N:10 |
| MINIMUM INTER-SIGNAL-POINT DISTANCE (1,X) | 4 | 5 |
| MINIMUM INTER-SIGNAL-POINT DISTANCE (2,X) | 58 | 58 |
| MINIMUM INTER-SIGNAL-POINT DISTANCE (3,X) | 111 | 111 |
| MINIMUM INTER-SIGNAL-POINT DISTANCE (4,X) | 164 | 164. |
| MINIMUM INTER-SIGNAL-POINT DISTANCE (5,X) | 216 | 217 |
| MINIMUM INTER-SIGNAL-POINT DISTANCE (6,X) | 165 | 162 |
| MINIMUM INTER-SIGNAL-POINT DISTANCE (7,X) | 109 | 111 |
| MINIMUM INTER-SIGNAL-POINT DISTANCE (8,X) | 56 | 56 |
| MINIMUM INTER-SIGNAL-POINT DISTANCE (9,X) | 4 | 3 |
|  |  |  |
|  |  |  |
| VARIANCE | 0.3857 | 0.3685 |
| TOTAL PATTERN(/(530*529/2) | 54066 | 51661 |
|  |  |  |
|  |  |  |

# FIG.13

| N\M | 1 | 2 | 3 | 4 | 5 | 6 | ··· |
|---|---|---|---|---|---|---|---|
| 1 | 1 | 2 | 4 | 8 | 16 | 32 | ··· |
| 2 | 2 | 4 | 8 | 16 | 32 | 11 | ··· |
| 3 | 4 | 8 | 16 | 32 | 11 | 22 | ··· |
| 4 | 8 | 16 | 32 | 11 | 22 | 44 | ... |
| 5 | 16 | 32 | 11 | 22 | 44 | 35 | ... |
| 6 | 32 | 11 | 22 | 44 | 35 | 17 | ··· |
| 7 | 11 | 22 | 44 | 35 | 17 | 34 | |
| 8 | 22 | 44 | 35 | 17 | 34 | 15 | ··· |
| 9 | 44 | 35 | 17 | 34 | 15 | 30 | ··· |
| 10 | 35 | 17 | 34 | 15 | 30 | 7 | ··· |

# FIG.14

| N \ M | 1 | 2 | 3 | 4 | 5 | 6 | ··· |
|---|---|---|---|---|---|---|---|
| 1 | 1 | 2 | 4 | 8 | 16 | 32 | ··· |
| 2 | 55 | 57 | 61 | 69 | 85 | 64 | ··· |
| 3 | 110 | ··· | ··· | ··· | ··· | ··· | ··· |
| 4 | 167 | ··· | ··· | ··· | ··· | ··· | ··· |
| 5 | 228 | ··· | ··· | ··· | ··· | ··· | ··· |
| 6 | 297 | ··· | ··· | ··· | ··· | ··· | ··· |
| 7 | 329 | ··· | ··· | ··· | ··· | ··· | ··· |
| 8 | 393 | ··· | ··· | ··· | ··· | ··· | ··· |
| 9 | 468 | ··· | ··· | ··· | ··· | ··· | ··· |
| 10 | 512 | ··· | ··· | ··· | ··· | ··· | ··· |

# FIG.15

| N \ M | 1 | 2 | 3 | 4 | 5 | 6 | |
|---|---|---|---|---|---|---|---|
| 1 | 512 | ··· | ··· | ··· | ··· | ··· | ··· |
| 2 | 468 | ··· | ··· | ··· | ··· | ··· | ··· |
| 3 | 393 | ··· | ··· | ··· | ··· | ··· | ··· |
| 4 | 329 | ··· | ··· | ··· | ··· | ··· | ··· |
| 5 | 297 | ··· | ··· | ··· | ··· | ··· | ··· |
| 6 | 228 | ··· | ··· | ··· | ··· | ··· | ··· |
| 7 | 167 | ··· | ··· | ··· | ··· | ··· | ··· |
| 8 | 110 | ··· | ··· | ··· | ··· | ··· | ··· |
| 9 | 55 | 57 | 61 | 69 | 85 | 64 | ··· |
| 10 | 1 | 2 | 4 | 8 | 16 | 32 | ··· |

# FIG.16

SUMMARY OF DATA

|  | PPI | PIL |
|---|---|---|
| NUMBER OF COLUM | M:53 | M:53 |
| NUMBER OF ROW | N:10 | N:10 |
| MINIMUM INTER-SIGNAL-POINT DISTANCE (1,X) | 27 | 5 |
| MINIMUM INTER-SIGNAL-POINT DISTANCE (2,X) | 67 | 58 |
| MINIMUM INTER-SIGNAL-POINT DISTANCE (3,X) | 117 | 111 |
| MINIMUM INTER-SIGNAL-POINT DISTANCE (4,X) | 167 | 164 |
| MINIMUM INTER-SIGNAL-POINT DISTANCE (5,X) | 225 | 217 |
| MINIMUM INTER-SIGNAL-POINT DISTANCE (6,X) | 172 | 162 |
| MINIMUM INTER-SIGNAL-POINT DISTANCE (7,X) | 114 | 111 |
| MINIMUM INTER-SIGNAL-POINT DISTANCE (8,X) | 64 | 56 |
| MINIMUM INTER-SIGNAL-POINT DISTANCE (9,X) | 14 | 3 |
|  |  |  |
| VARIANCE | 0.2244 | 0.3685 |
| TOTAL PATTERN(/(530*529/2) | 31464 | 51661 |
|  |  |  |

# FIG.17

SUMMARY OF DATA

| | PPI (DISTANCE BETWEEN u1 AND 2u: FIVE ROWS) |
|---|---|
| Number of Colum | M:53 |
| Number of Row | N:10 |
| MINIMUM INTER-SIGNAL-POINT DISTANCE (0,X) | 265 |
| MINIMUM INTER-SIGNAL-POINT DISTANCE (1,X) | 163 |
| MINIMUM INTER-SIGNAL-POINT DISTANCE (2,X) | 111 |
| MINIMUM INTER-SIGNAL-POINT DISTANCE (3,X) | 57 |
| MINIMUM INTER-SIGNAL-POINT DISTANCE (4,X) | 5 |
| MINIMUM INTER-SIGNAL-POINT DISTANCE (5,X) | 1 |
| MINIMUM INTER-SIGNAL-POINT DISTANCE (6,X) | 3 |
| MINIMUM INTER-SIGNAL-POINT DISTANCE (7,X) | 58 |
| MINIMUM INTER-SIGNAL-POINT DISTANCE (8,X) | 109 |
| MINIMUM INTER-SIGNAL-POINT DISTANCE (9,X) | 163 |

# FIG.18

SUMMARY OF DATA

| | PPI (DISTANCE BETWEEN u1 AND 2u: NINE ROWS) |
|---|---|
| Number of Colum | M:53 |
| Number of Row | N:10 |
| MINIMUM INTER-SIGNAL-POINT DISTANCE (0,X) | 53 |
| MINIMUM INTER-SIGNAL-POINT DISTANCE (1,X) | 59 |
| MINIMUM INTER-SIGNAL-POINT DISTANCE (2,X) | 111 |
| MINIMUM INTER-SIGNAL-POINT DISTANCE (3,X) | 164 |
| MINIMUM INTER-SIGNAL-POINT DISTANCE (4,X) | 217 |
| MINIMUM INTER-SIGNAL-POINT DISTANCE (5,X) | 164 |
| MINIMUM INTER-SIGNAL-POINT DISTANCE (6,X) | 109 |
| MINIMUM INTER-SIGNAL-POINT DISTANCE (7,X) | 56 |
| MINIMUM INTER-SIGNAL-POINT DISTANCE (8,X) | 3 |
| MINIMUM INTER-SIGNAL-POINT DISTANCE (9,X) | 1 |

# FIG.19

(a)

(b)

# FIG.20

EP 2 299 598 A2

| M\N | 1 | 2 | 3 | 4 | 5 | 6 | 7 | 8 | 9 | 10 | 11 | 12 | 13 | 14 | 15 | 16 | 17 | 18 | 19 | 20 |
|---|---|---|---|---|---|---|---|---|---|---|---|---|---|---|---|---|---|---|---|---|
| 1 | 1 | 19 | 43 | 22 | 47 | 45 | 7 | 27 | 36 | 48 | 11 | 50 | 49 | 30 | 40 | 18 | 24 | 32 | 25 | 51 |
| 2 | 1 | 21 | 17 | 39 | 24 | 27 | 37 | 35 | 46 | 12 | 40 | 45 | 44 | 23 | 6 | 20 | 49 | 22 | 38 | 3 |
| 3 | 1 | 45 | 11 | 18 | 15 | 39 | 6 | 5 | 13 | 2 | 37 | 22 | 36 | 30 | 25 | 12 | 10 | 26 | 4 | 21 |
| 4 | 1 | 33 | 29 | 3 | 46 | 34 | 9 | 32 | 49 | 27 | 43 | 41 | 28 | 23 | 17 | 31 | 16 | 51 | 40 | 48 |
| 5 | 1 | 12 | 38 | 32 | 13 | 50 | 17 | 45 | 10 | 14 | 9 | 2 | 24 | 23 | 11 | 26 | 47 | 34 | 37 | 20 |
| 6 | 1 | 3 | 9 | 27 | 28 | 31 | 40 | 14 | 42 | 20 | 7 | 21 | 10 | 30 | 37 | 5 | 15 | 45 | 29 | 34 |
| 7 | 1 | 30 | 52 | 23 | 1 | 30 | 52 | 23 | 1 | 30 | 52 | 23 | 1 | 30 | 52 | 23 | 1 | 30 | 52 | 23 |
| 8 | 1 | 34 | 43 | 31 | 47 | 8 | 7 | 26 | 36 | 5 | 11 | 3 | 49 | 23 | 40 | 35 | 24 | 21 | 25 | 2 |
| 9 | 1 | 22 | 7 | 48 | 49 | 18 | 25 | 20 | 16 | 34 | 6 | 26 | 42 | 23 | 29 | 2 | 44 | 14 | 43 | 45 |
| 10 | 1 | 2 | 4 | 8 | 16 | 32 | 11 | 22 | 44 | 35 | 17 | 34 | 15 | 30 | 7 | 14 | 28 | 3 | 6 | 12 |

| M\N | 21 | 22 | 23 | 24 | 25 | 26 | 27 | 28 | 29 | 30 | 31 | 32 | 33 | 34 | 35 | 36 | 37 | 38 | 39 | 40 |
|---|---|---|---|---|---|---|---|---|---|---|---|---|---|---|---|---|---|---|---|---|
| 1 | 15 | 20 | 9 | 12 | 16 | 39 | 52 | 34 | 10 | 31 | 6 | 8 | 46 | 26 | 17 | 5 | 42 | 3 | 4 | 23 |
| 2 | 10 | 51 | 11 | 19 | 28 | 5 | 52 | 32 | 36 | 14 | 29 | 26 | 16 | 18 | 7 | 41 | 13 | 8 | 9 | 30 |
| 3 | 44 | 19 | 7 | 50 | 24 | 20 | 32 | 8 | 42 | 35 | 38 | 14 | 47 | 48 | 40 | 51 | 16 | 31 | 17 | 23 |
| 4 | 47 | 14 | 38 | 35 | 42 | 8 | 52 | 20 | 24 | 50 | 7 | 19 | 44 | 21 | 4 | 26 | 10 | 12 | 25 | 30 |
| 5 | 28 | 18 | 4 | 48 | 46 | 22 | 52 | 41 | 15 | 21 | 40 | 3 | 36 | 8 | 43 | 39 | 44 | 51 | 29 | 30 |
| 6 | 49 | 41 | 17 | 51 | 47 | 35 | 52 | 50 | 44 | 26 | 25 | 22 | 13 | 39 | 11 | 33 | 46 | 32 | 43 | 23 |
| 7 | 1 | 30 | 52 | 23 | 1 | 30 | 52 | 23 | 1 | 30 | 52 | 23 | 1 | 30 | 52 | 23 | 1 | 30 | 52 | 23 |
| 8 | 15 | 33 | 9 | 41 | 16 | 14 | 52 | 19 | 10 | 22 | 6 | 45 | 46 | 27 | 17 | 48 | 42 | 50 | 4 | 30 |
| 9 | 36 | 50 | 40 | 32 | 15 | 12 | 52 | 31 | 46 | 5 | 4 | 35 | 28 | 33 | 37 | 19 | 47 | 27 | 11 | 30 |
| 10 | 24 | 48 | 43 | 33 | 13 | 26 | 52 | 51 | 49 | 45 | 37 | 21 | 42 | 31 | 9 | 18 | 36 | 19 | 38 | 23 |

| M\N | 41 | 42 | 43 | 44 | 45 | 46 | 47 | 48 | 49 | 50 | 51 | 52 | 53 |
|---|---|---|---|---|---|---|---|---|---|---|---|---|---|
| 1 | 13 | 35 | 29 | 21 | 28 | 2 | 38 | 33 | 44 | 41 | 37 | 14 | 0 |
| 2 | 47 | 33 | 4 | 31 | 15 | 50 | 43 | 2 | 42 | 34 | 25 | 48 | 0 |
| 3 | 28 | 41 | 43 | 27 | 49 | 32 | 9 | 34 | 46 | 3 | 29 | 33 | 0 |
| 4 | 36 | 22 | 37 | 2 | 13 | 5 | 6 | 39 | 15 | 18 | 11 | 45 | 0 |
| 5 | 42 | 27 | 6 | 19 | 16 | 33 | 25 | 35 | 49 | 5 | 7 | 31 | 0 |
| 6 | 16 | 48 | 38 | 8 | 24 | 19 | 4 | 12 | 36 | 2 | 6 | 18 | 0 |
| 7 | 1 | 30 | 52 | 23 | 1 | 30 | 52 | 23 | 1 | 30 | 52 | 23 | 0 |
| 8 | 13 | 18 | 29 | 32 | 28 | 51 | 38 | 20 | 44 | 12 | 37 | 39 | 0 |
| 9 | 24 | 51 | 9 | 39 | 10 | 8 | 17 | 3 | 13 | 21 | 38 | 41 | 0 |
| 10 | 45 | 39 | 25 | 50 | 47 | 41 | 29 | 5 | 10 | 20 | 40 | 27 | 0 |

FIG.21

| N\M | 1 | 2 | 3 | 4 | 5 | 6 | 7 | 8 | 9 | 10 | 11 | 12 | 13 | 14 | 15 | 16 | 17 | 18 | 19 | 20 |
|---|---|---|---|---|---|---|---|---|---|---|---|---|---|---|---|---|---|---|---|---|
| 1 | 1 | 19 | 43 | 22 | 47 | 45 | 7 | 27 | 36 | 48 | 11 | 50 | 49 | 30 | 40 | 18 | 24 | 32 | 25 | 51 |
| 2 | 54 | 74 | 70 | 92 | 77 | 80 | 90 | 88 | 99 | 65 | 93 | 98 | 97 | 76 | 59 | 73 | 102 | 75 | 91 | 56 |
| 3 | 107 | 151 | 117 | 124 | 121 | 145 | 112 | 111 | 119 | 108 | 143 | 128 | 142 | 136 | 131 | 118 | 116 | 132 | 110 | 127 |
| 4 | 160 | 192 | 188 | 162 | 205 | 193 | 168 | 191 | 208 | 186 | 202 | 200 | 187 | 182 | 176 | 190 | 175 | 210 | 199 | 207 |
| 5 | 213 | 224 | 250 | 244 | 225 | 262 | 229 | 257 | 222 | 226 | 221 | 214 | 236 | 235 | 223 | 238 | 259 | 246 | 249 | 232 |
| 6 | 266 | 268 | 274 | 292 | 293 | 296 | 305 | 279 | 307 | 285 | 272 | 286 | 275 | 295 | 302 | 270 | 280 | 310 | 294 | 299 |
| 7 | 319 | 348 | 370 | 341 | 319 | 348 | 370 | 341 | 319 | 348 | 370 | 341 | 319 | 348 | 370 | 341 | 319 | 388 | 370 | 341 |
| 8 | 372 | 405 | 414 | 402 | 418 | 379 | 378 | 397 | 407 | 376 | 382 | 374 | 420 | 394 | 411 | 406 | 395 | 392 | 396 | 373 |
| 9 | 425 | 446 | 431 | 472 | 473 | 442 | 449 | 444 | 440 | 458 | 430 | 450 | 466 | 447 | 453 | 426 | 468 | 430 | 467 | 469 |
| 10 | 478 | 479 | 481 | 485 | 493 | 509 | 488 | 499 | 521 | 512 | 494 | 511 | 492 | 507 | 484 | 491 | 505 | 480 | 483 | 489 |

| N\M | 21 | 22 | 23 | 24 | 25 | 26 | 27 | 28 | 29 | 30 | 31 | 32 | 33 | 34 | 35 | 36 | 37 | 38 | 39 | 40 |
|---|---|---|---|---|---|---|---|---|---|---|---|---|---|---|---|---|---|---|---|---|
| 1 | 15 | 20 | 9 | 12 | 16 | 39 | 52 | 34 | 10 | 31 | 6 | 8 | 46 | 26 | 17 | 5 | 42 | 3 | 4 | 23 |
| 2 | 63 | 104 | 64 | 72 | 81 | 58 | 105 | 85 | 89 | 67 | 82 | 79 | 69 | 71 | 60 | 94 | 66 | 61 | 62 | 83 |
| 3 | 150 | 125 | 113 | 156 | 130 | 126 | 158 | 114 | 148 | 141 | 144 | 120 | 153 | 154 | 146 | 157 | 122 | 137 | 123 | 129 |
| 4 | 206 | 173 | 197 | 194 | 201 | 167 | 211 | 179 | 183 | 209 | 166 | 178 | 203 | 180 | 163 | 185 | 169 | 171 | 184 | 189 |
| 5 | 240 | 230 | 216 | 260 | 258 | 234 | 264 | 253 | 227 | 233 | 252 | 215 | 246 | 220 | 255 | 251 | 256 | 263 | 241 | 242 |
| 6 | 314 | 306 | 282 | 316 | 312 | 300 | 319 | 315 | 309 | 291 | 290 | 287 | 218 | 304 | 276 | 298 | 311 | 297 | 308 | 288 |
| 7 | 319 | 348 | 370 | 341 | 319 | 348 | 370 | 341 | 319 | 348 | 370 | 341 | 319 | 348 | 370 | 341 | 319 | 348 | 370 | 341 |
| 8 | 386 | 404 | 380 | 412 | 387 | 385 | 423 | 390 | 381 | 393 | 377 | 416 | 417 | 398 | 388 | 419 | 413 | 421 | 375 | 401 |
| 9 | 460 | 474 | 464 | 456 | 439 | 436 | 476 | 455 | 470 | 429 | 428 | 459 | 452 | 457 | 461 | 443 | 471 | 451 | 435 | 454 |
| 10 | 501 | 525 | 520 | 510 | 490 | 503 | 529 | 528 | 526 | 522 | 514 | 498 | 519 | 508 | 486 | 495 | 543 | 496 | 515 | 500 |

| N\M | 41 | 42 | 43 | 44 | 45 | 46 | 47 | 48 | 49 | 50 | 51 | 52 | 53 |
|---|---|---|---|---|---|---|---|---|---|---|---|---|---|
| 1 | 13 | 35 | 29 | 21 | 28 | 2 | 38 | 33 | 44 | 41 | 37 | 14 | 0 |
| 2 | 100 | 86 | 57 | 84 | 68 | 103 | 96 | 55 | 95 | 87 | 78 | 101 | 53 |
| 3 | 134 | 147 | 149 | 133 | 155 | 138 | 115 | 140 | 152 | 109 | 135 | 139 | 106 |
| 4 | 195 | 181 | 196 | 161 | 172 | 164 | 165 | 198 | 174 | 177 | 170 | 204 | 159 |
| 5 | 254 | 239 | 218 | 231 | 228 | 245 | 237 | 247 | 261 | 217 | 219 | 243 | 212 |
| 6 | 281 | 313 | 303 | 273 | 289 | 284 | 269 | 277 | 301 | 267 | 271 | 283 | 265 |
| 7 | 319 | 348 | 370 | 341 | 319 | 348 | 370 | 341 | 319 | 348 | 370 | 341 | 318 |
| 8 | 384 | 389 | 400 | 403 | 399 | 422 | 409 | 391 | 415 | 383 | 408 | 410 | 371 |
| 9 | 448 | 475 | 433 | 463 | 434 | 432 | 441 | 427 | 437 | 445 | 462 | 465 | 424 |
| 10 | 523 | 516 | 502 | 527 | 524 | 518 | 506 | 482 | 487 | 497 | 517 | 504 | 477 |

FIG.22

| M\N | 1 | 2 | 3 | 4 | 5 | 6 | 7 | 8 | 9 | 10 | 11 | 12 | 13 | 14 | 15 | 16 | 17 | 18 | 19 | 20 |
|---|---|---|---|---|---|---|---|---|---|---|---|---|---|---|---|---|---|---|---|---|
| 1 | 478 | 479 | 481 | 485 | 493 | 509 | 488 | 499 | 521 | 512 | 494 | 511 | 492 | 507 | 484 | 491 | 505 | 480 | 483 | 489 |
| 2 | 425 | 446 | 431 | 472 | 473 | 442 | 449 | 444 | 440 | 458 | 430 | 450 | 466 | 447 | 453 | 426 | 468 | 438 | 467 | 469 |
| 3 | 372 | 405 | 414 | 402 | 418 | 379 | 378 | 397 | 407 | 376 | 382 | 374 | 420 | 394 | 411 | 406 | 395 | 392 | 396 | 373 |
| 4 | 319 | 348 | 370 | 341 | 319 | 348 | 370 | 341 | 319 | 348 | 370 | 341 | 319 | 348 | 370 | 341 | 319 | 348 | 370 | 341 |
| 5 | 266 | 268 | 274 | 292 | 293 | 296 | 305 | 279 | 307 | 285 | 272 | 286 | 275 | 295 | 302 | 270 | 280 | 310 | 294 | 299 |
| 6 | 213 | 224 | 250 | 244 | 225 | 262 | 229 | 257 | 222 | 226 | 221 | 214 | 236 | 235 | 223 | 238 | 259 | 246 | 249 | 232 |
| 7 | 160 | 192 | 188 | 162 | 205 | 193 | 168 | 191 | 208 | 186 | 202 | 200 | 187 | 182 | 176 | 190 | 175 | 210 | 199 | 207 |
| 8 | 107 | 151 | 117 | 124 | 121 | 145 | 112 | 111 | 119 | 108 | 143 | 128 | 142 | 136 | 131 | 118 | 116 | 132 | 110 | 127 |
| 9 | 54 | 74 | 70 | 92 | 77 | 80 | 90 | 88 | 99 | 65 | 93 | 98 | 97 | 76 | 59 | 73 | 102 | 75 | 91 | 56 |
| 10 | 1 | 19 | 43 | 22 | 47 | 45 | 7 | 27 | 36 | 48 | 11 | 50 | 49 | 30 | 40 | 18 | 24 | 32 | 25 | 51 |

| M\N | 21 | 22 | 23 | 24 | 25 | 26 | 27 | 28 | 29 | 30 | 31 | 32 | 33 | 34 | 35 | 36 | 37 | 38 | 39 | 40 |
|---|---|---|---|---|---|---|---|---|---|---|---|---|---|---|---|---|---|---|---|---|
| 1 | 501 | 525 | 520 | 510 | 490 | 503 | 529 | 528 | 526 | 522 | 514 | 498 | 519 | 508 | 486 | 495 | 513 | 496 | 515 | 500 |
| 2 | 460 | 474 | 464 | 456 | 439 | 436 | 476 | 455 | 470 | 429 | 428 | 459 | 452 | 457 | 461 | 443 | 471 | 451 | 435 | 454 |
| 3 | 386 | 404 | 380 | 412 | 387 | 385 | 423 | 390 | 381 | 393 | 377 | 416 | 417 | 398 | 388 | 419 | 413 | 421 | 375 | 401 |
| 4 | 319 | 348 | 370 | 341 | 319 | 348 | 370 | 341 | 319 | 348 | 370 | 341 | 319 | 348 | 370 | 341 | 319 | 348 | 370 | 341 |
| 5 | 314 | 306 | 282 | 316 | 312 | 300 | 317 | 315 | 309 | 291 | 290 | 287 | 278 | 304 | 276 | 298 | 311 | 297 | 308 | 288 |
| 6 | 240 | 230 | 216 | 260 | 258 | 234 | 264 | 253 | 227 | 233 | 252 | 215 | 248 | 220 | 255 | 251 | 256 | 263 | 241 | 242 |
| 7 | 206 | 173 | 197 | 194 | 201 | 167 | 211 | 179 | 183 | 209 | 166 | 178 | 203 | 180 | 163 | 185 | 169 | 171 | 184 | 189 |
| 8 | 150 | 125 | 113 | 156 | 130 | 126 | 158 | 114 | 148 | 141 | 144 | 120 | 153 | 154 | 146 | 157 | 122 | 137 | 123 | 129 |
| 9 | 63 | 104 | 64 | 72 | 81 | 58 | 105 | 85 | 89 | 67 | 82 | 79 | 69 | 71 | 60 | 94 | 66 | 61 | 62 | 83 |
| 10 | 15 | 20 | 9 | 12 | 16 | 39 | 52 | 34 | 10 | 31 | 6 | 8 | 46 | 26 | 17 | 5 | 42 | 3 | 4 | 23 |

| M\N | 41 | 42 | 43 | 44 | 45 | 46 | 47 | 48 | 49 | 50 | 51 | 52 | 53 |
|---|---|---|---|---|---|---|---|---|---|---|---|---|---|
| 1 | 523 | 516 | 502 | 527 | 524 | 518 | 506 | 482 | 487 | 497 | 517 | 504 | 477 |
| 2 | 448 | 475 | 433 | 463 | 434 | 432 | 441 | 427 | 437 | 445 | 462 | 465 | 424 |
| 3 | 384 | 389 | 400 | 403 | 399 | 422 | 409 | 391 | 415 | 383 | 408 | 410 | 371 |
| 4 | 319 | 348 | 370 | 341 | 319 | 348 | 370 | 341 | 319 | 343 | 370 | 341 | 318 |
| 5 | 281 | 313 | 303 | 273 | 289 | 284 | 269 | 277 | 301 | 267 | 271 | 283 | 265 |
| 6 | 254 | 239 | 218 | 231 | 228 | 245 | 237 | 247 | 261 | 217 | 219 | 243 | 212 |
| 7 | 195 | 101 | 196 | 161 | 172 | 164 | 165 | 198 | 174 | 177 | 170 | 204 | 159 |
| 8 | 134 | 147 | 149 | 133 | 155 | 138 | 115 | 140 | 152 | 109 | 135 | 139 | 106 |
| 9 | 100 | 86 | 57 | 84 | 68 | 103 | 96 | 55 | 95 | 87 | 78 | 101 | 53 |
| 10 | 13 | 35 | 29 | 21 | 28 | 2 | 38 | 33 | 44 | 41 | 37 | 14 | 0 |

FIG.23

33

# FIG.24